Europäisches Patentamt

European Patent Office

Office européen des brevets

(19)

(11)    EP 1 202 459 B1

(12)    EUROPEAN PATENT SPECIFICATION

(45) Date of publication and mention
of the grant of the patent:
**10.05.2006   Bulletin 2006/19**

(51) Int Cl.:
***H03M 1/06*** *(2006.01)*        *H03M 1/74* *(2006.01)*

(21) Application number: **01307719.3**

(22) Date of filing: **11.09.2001**

(54) **Segmented circuitry**

Segmentierte Schaltungsanordnung

Agencement de circuit segmenté

(84) Designated Contracting States:
**DE FR GB**

(30) Priority:  **26.10.2000   EP 00309413**
**18.01.2001   GB 0101307**

(43) Date of publication of application:
**02.05.2002   Bulletin 2002/18**

(60) Divisional application:
**05023070.5 / 1 622 272**

(73) Proprietor: **FUJITSU LIMITED**
**Kawasaki-shi,**
**Kanagawa 211-8588 (JP)**

(72) Inventors:
• **Dedic, Ian Juso**
**Northolt,**
**Middlesex UB5 5HW (GB)**
• **Patel, Sanjay Ashwin-Kumar Umedbhai**
**Reading,**
**Berkshire RG1 8HA (GB)**

(74) Representative: **Hitching, Peter Matthew et al**
**Haseltine Lake & Co.,**
**Imperial House,**
**15-19 Kingsway**
**London WC2B 6UD (GB)**

(56) References cited:
**EP-A- 0 280 277        EP-A- 0 740 424**
**EP-A- 0 898 374        EP-A- 0 899 645**
**US-A- 5 793 231**

• **TIEN-YU WU ET AL: "A LOW GLITCH 10-BIT 75-MHZ CMOS VIDEO D/A CONVERTER" IEEE JOURNAL OF SOLID-STATE CIRCUITS, IEEE INC. NEW YORK, US, vol. 30, no. 1, 1995, pages 68-72, XP000495351 ISSN: 0018-9200**
• **YASUYUKI NAKAMURA: "A 10-B 70-MS/S CMOS D/A CONVERTER" IEEE JOURNAL OF SOLID-STATE CIRCUITS, IEEE INC. NEW YORK, US, vol. 26, no. 4, 1 April 1991 (1991-04-01), pages 637-642, XP000216739 ISSN: 0018-9200**

**Description**

The present invention relates to segmented circuitry such as, for example, digital-to-analog converters.

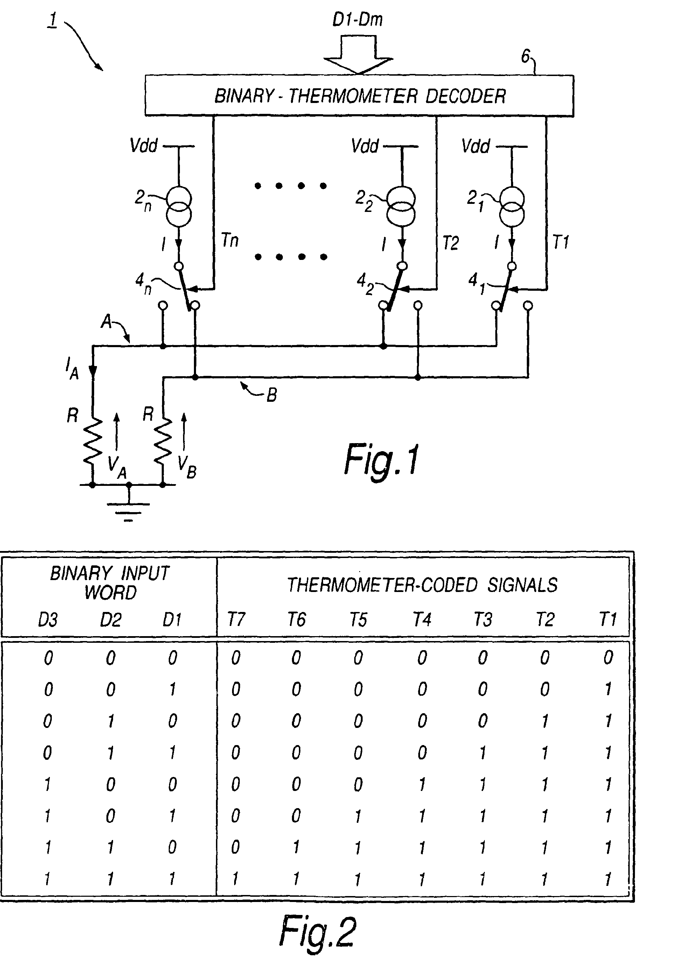

Fig. 1 of the accompanying drawings shows parts of a conventional digital-to-analog converter (DAC) of the so-called "current-steering" type. The DAC 1 is designed to convert an m-bit digital input word (D1-Dm) into a corresponding analog output signal.

The DAC 1 includes a plurality (n) of identical current sources $2_1$ to $2_n$, where $n=2^m-1$. Each current source 2 passes a substantially constant current I. The DAC 1 further includes a plurality of differential switching circuits $4_1$ to $4_n$ corresponding respectively to the n current sources $2_1$ to $2_n$. Each differential switching circuit 4 is connected to its corresponding current source 2 and switches the current I produced by the current source either to a first terminal, connected to a first connection line A of the converter, or a second terminal connected to a second connection line B of the converter.

Each differential switching circuit 4 receives one of a plurality of control signals T1 to Tn (called "thermometer-coded signals" for reasons explained hereinafter) and selects either its first terminal or its second terminal in accordance with the value of the signal concerned. A first output current $I_A$ of the DAC 1 is the sum of the respective currents delivered to the differential-switching-circuit first terminals, and a second output current $I_B$ of the DAC 1 is the sum of the respective currents delivered to the differential-switching-circuit second terminals.

The analog output signal is the voltage difference $V_A$-$V_B$ between a voltage $V_A$ produced by sinking the first output current $I_A$ of the DAC 1 into a resistance R and a voltage $V_B$ produced by sinking the second output current $I_B$ of the converter into another resistance R.

In the Fig. 1 DAC the thermometer-coded signals T1 to Tn are derived from the binary input word D1-Dm by a binary-thermometer decoder 6. The decoder 6 operates as follows.

When the binary input word D1-Dm has the lowest value the thermometer-coded signals T1-Tn are such that each of the differential switching circuits $4_1$ to $4_n$ selects its second terminal so that all of the current sources $2_1$ to $2_n$ are connected to the second connection line B. In this state, $V_A = 0$ and $V_B = nIR$. The analog output signal $V_A$-$V_B$ is -nIR.

As the binary input word D1-Dm increases progressively in value, the thermometer-coded signals T1 to Tn produced by the decoder 6 are such that more of the differential switching circuits select their respective first terminals (starting from the differential switching circuit $4_1$) without any differential switching circuit that has already selected its first terminal switching back to its second terminal. When the binary input word D1-Dm has the value i, the first i differential switching circuits $4_1$ to $4_i$ select their respective first terminals, whereas the remaining n-i differential switching circuits $4_{i+1}$ to $4_n$ select their respective second terminals. The analog output signal $V_A$-$V_B$ is equal to (2i-n)IR.

Fig. 2 of the accompanying drawings shows an example of the thermometer-coded signals generated for a three-bit binary input word D1-D3 (i.e. in this example m=3). In this case, seven thermometer-coded signals T1 to T7 are required ($n=2^m -1 = 7$).

As Fig. 2 shows, the thermometer-coded signals T1 to Tn generated by the binary-thermometer decoder 6 follow a so-called thermometer code in which it is known that when an rth-order signal Tr is activated (set to "1"), all of the lower-order signals T1 to Tr-1 will also be activated.

Thermometer coding is popular in DACs of the current-steering type because, as the binary input word increases, more current sources are switched to the first connection line A without any current source that is already switched to that line A being switched to the other line B. Accordingly, the input/output characteristic of the DAC is monotonic and the glitch impulse resulting from a change of 1 in the input word is small.

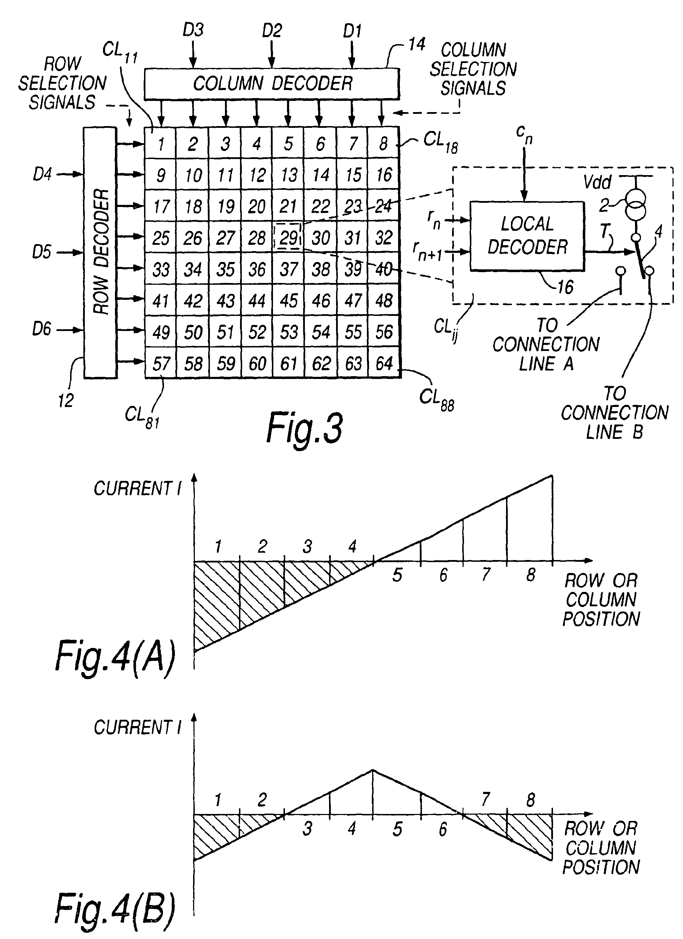

It will be appreciated that the number of current sources 2 and corresponding differential switching circuits 4 in the Fig. 1 architecture is quite large, particularly when m is greater than or equal to 6. When m = 6, for example, n = 63, and 63 current sources and 63 differential switching circuits are required. In order to deal with such a large number of current sources, and to enable the thermometer signals to be delivered efficiently to the different differential switching circuits, it has been proposed to arrange the current sources and differential switching circuits as a two-dimensional array of cells, each cell including one current source and its associated differential switching circuit. This arrangement is shown in Fig. 3 of the accompanying drawings.

In Fig. 3, 64 cells $CL_{ij}$ are arranged in an 8 x 8 square array having eight rows and eight columns. In Fig. 3, the first digit of the suffix applied to each cell denotes the row in which the cell is located and the second digit of the suffix denotes the column in which the cell is located. Thus, the cell $CL_{18}$ is the cell in row 1, column 8.

Each cell $CL_{ij}$ includes its own current source 2 and its own differential switching circuit 4. The respective first terminals of the cells of the array are connected together to a first connection line A of the DAC and the respective second terminals of the cells of the array are connected together to a second connection line B of the DAC, as in the Fig. 1 DAC.

The numbers allotted to the cells $CL_{ij}$ in Fig. 3 denote the sequence in which the cells are activated (or controlled) to change from selecting their respective second terminals to selecting their respective first terminals. The activation sequence follows the physical order of the cells in the array, starting from row 1 and activating the cells of that row sequentially in column order, followed by row 2, and so on for each successive row of the array.

One problem which arises in the Fig. 3 arrangement is that, although the output currents of the respective current sources 2 of the different cells of the array should be uniform, in practice the actual output currents of the cells suffer from non-uniformity arising from various causes.

For example, a voltage drop along a power supply line can cause a graded error along a row or column, as shown in Fig. 4(A) of the accompanying drawings. In this case, the current sources in the first four cells of the row or column concerned may have negative errors, signifying that each of them produces a below-average output current. These negative errors decrease towards the centre of the row or column concerned. The current sources in the remaining cells 5 to 8 of the row or column concerned have respective positive errors, signifying that each of them produces an above-average output current. These positive errors increase from the centre of the row or column to the end.

Thermal distribution inside a chip including the array can cause a symmetrical error within a row or column, as shown in Fig. 4(B) of the accompanying drawings. In this case, the current sources in the end cells 1, 2, 7 and 8 of the row or column have negative errors, whereas the current sources of the central cells 3 to 6 of the row or column have positive errors.

In addition, there can be other types of error such as random errors, discussed in more detail below. The final error distribution for the cell array is produced by superposing all the different error components.

The graded and symmetrical errors shown in Figs. 4(A) and Fig. 4(B) tend to accumulate and result in a large integral linearity error (INL). For example, imagine that the graded error distribution shown in Fig. 4(A) exists within the first row of the cell array shown in Fig. 3. In this case, as cells 1 to 4 are progressively activated (changed from selecting their respective second terminals to selecting their respective first terminals) the negative errors accumulate, amounting to a significant total negative error when the digital input code is 4. Only when cells 5 to 8 are sequentially activated do the positive errors attributable to these cells start to cancel out the large negative error attributable to cells 1 to 4.

Of course the situation is even worse if there are graded errors corresponding to Fig. 4(A) along each of the columns 1 to 8. In this case, as cells 1 to 8 are progressively activated, the largest negative error (the error at position 1 in Fig. 4(A)) occurs for each of the eight cells of row 1. Similarly, in row 2, negative errors corresponding to position 2 in Fig. 4(A) accumulate eight times. Thus, by the time the input code has increased to 32 (corresponding to all of the cells in rows 1 to 4 being activated) the accumulated negative error is very large indeed.

Similar problems arise with the accumulation of symmetrical errors of the kind shown in Fig. 4(B).

Mismatches due to graded and symmetrical errors can be reduced by selecting the cells in a special sequence different from the sequence in which they are arranged physically in the cell array. In particular, a special cell selection sequence conforming to the sequence of numbers in a so-called "magic square" is described in the applicant's co-pending European patent publication no. EP-A-0929158 (corresponding to United Kingdom patent publication no. GB-A-2333190), the entire content of which is incorporated herein by reference.

However, even when such a special cell selection sequence is employed, there inevitably remains a mismatch between the respective currents produced by the different segments. This in turn causes non-linearity in the performance of the DAC.

It has been proposed in a paper entitled "Structural Optimization and Scaling of SC Delta-Sigma ADCs", Jesper Steensgaard, Delta-Sigma Data Converters Lecture Course, March 16-19 1999, San Diego, California, to employ element (or segment) rotation to shape mismatches between the elements of a DAC. In this proposal, the elements are rotated using data-directed rotation amounts. Another paper from the same lecture course, entitled "Mismatch-Shaping Multibit DACs for Delta-Sigma ADCs and DACs, Ian Galton, discloses mismatch shaping techniques which move noise from low frequencies to high frequencies to improve the noise shape. In these techniques the noise increases rapidly with frequency at high output-signal frequencies, so large oversampling ratios (e.g. 8 or 25) must be used to obtain useful results. A further paper from the same lecture course, entitled "Unconventional Applications of Noise-Shaping Techniques", Bob Adams, discloses that element "scrambling" can be employed in a sigma-delta DAC to turn distortion into shaped noise. The scrambling can be either random, which distributes the noise evenly across the entire frequency spectrum both within and outside the desired range of frequencies of the output signal, or data-directed which moves the noise away from DC but has noise that increases in amplitude progressively with frequency.

A technique has also been proposed, in our co-pending European patent publication no. EP-A-1100203, the entire content of which is incorporated herein by reference, which employs segment rotation, by amounts which are not data-directed, to shape mismatches between the segments of a DAC in order to shift noise out of a particular band of interest.

The above-described techniques are employed in order to overcome or alleviate the problems caused by graded, symmetrical and random errors in the segment sources of a particular device. However, there still remains a significant variation in performance from one device to the next due to the random source mismatches, as will now be described in more detail.

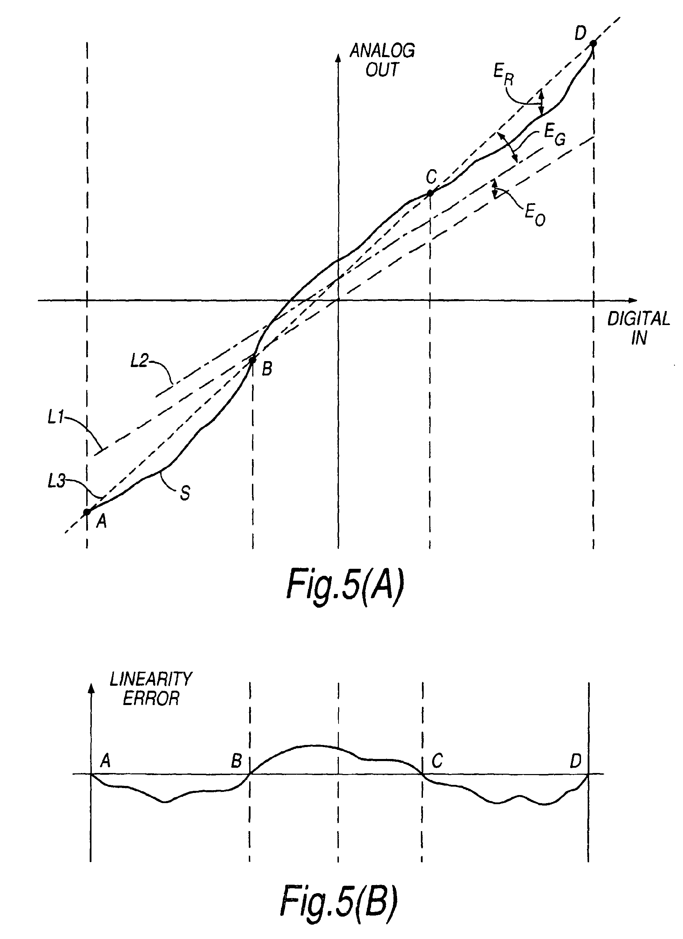

Fig. 5(A) of the accompanying drawings is a graph in which line S illustrates how an analog output signal varies with the binary input signal D1-Dm in an example bipolar DAC device. Line L1 represents the ideal input-output behaviour in such a device, where the analog output accurately follows the digital input in a linear fashion. As described above, in a real device various errors are inevitably present which cause the actual output analog signal to depart from ideal (line L1), as follows. The errors have been exaggerated for the purposes of this illustration.

An offset error causes the idealised output signal represented by line L1 to shift up by a certain amount $E_O$ for all digital input values, as illustrated by line L2. A gain error alters the gradient of the response curve to cause the offset error line L2 to rotate by an amount $E_G$ as illustrated by line L3. Finally, residual errors such as random errors, arising from source mismatches, cause the actual analog output signal to depart from line L3 by residual (random) error amounts $E_R$ which vary as the binary input signal varies. The lines L1, L2 and L3 are of course artificial representations used for the purposes of this explanation, with the line L3 drawn so as to pass through the actual analog output signal values (A and D in Figure 5(A)) at the extremities of the digital input range.

Fig. 5(B) of the accompanying drawings is a plot corresponding to Fig. 5(A) but showing the difference in output-signal value between lines S and L3 in Fig. 5(A) as the digital input signal is varied. Thus, the plot of Fig. 5(B) represents graphically the extent of the departure of the actual output signal of Fig. 5(A) from linearity; Fig. 5(B) does not take into account the offset and gain errors $E_O$ and $E_G$ mentioned above. The plot in Fig. 5(B) therefore shows the departure from the artificial linearity represented by line L3 which is constructed so as to be coincident with line S at points A and D, and not the departure from the ideal linearity represented by line L1. The plot in Fig. 5(B) also returns to zero at points B and C where the line S crosses line L3.

Such a plot as that in Fig. 5(B) for a particular DAC device is referred to herein as the "transfer function" of the device. Since the horizontal axis represents a digital input signal incrementing by discrete steps, the transfer function actually varies in a stepwise fashion.

An equation defining the transfer function (non-linearity error) E can be derived by considering the Fig. 1 DAC in more detail. Although the n current sources $2_1$ to $2_n$ ideally generate identical currents I, in practice the current sources will have respective current errors $e_1$ to $e_n$ which may be positive, negative or zero. The DAC of Fig. 1 has a differential output signal $I_A$-$I_B$, where for a digital input-signal value (D1-Dm) of x:

$$I_A = \sum_{i=1}^{x}(I + e_i)$$

$$I_B = \sum_{i=x+1}^{n}(I + e_i)$$

with associated errors $E(I_A)$ and $E(I_B)$ given respectively by:

$$E(I_A) = \sum_{i=1}^{x} e_i$$

$$E(I_B) = \sum_{i=x+1}^{n} e_i$$

such that the overall error E(I) is given by:

$$E(I) = E(I_A - I_B) = E(I_A) - E(I_B) = \sum_{i=1}^{x} e_i - \sum_{i=x+1}^{n} e_i$$

In this expression for the error E(I), the offset error $E_O$ described above with reference to Fig. 5(A) has been ignored. The gain error $E_G$ described above with reference to Fig. 5(A) can also be eliminated from this expression for E(I) by considering the mean $\mu$ of the errors $e_1$ to $e_n$:

$$\mu = \left(\sum_{i=1}^{n} e_i\right) / n$$

A non-zero value of the mean $\mu$ for a device causes the gain error $E_G$ described above with reference to Fig. 5(A), since every current source contributes, on average, an error of $\mu$ to the line A or B to which it is connected, resulting in an overall change in the slope of the input-output response. The gain error $E_G$ can be eliminated from the expression for the error E(I) by subtracting the mean error $\mu$ from each of the current source errors $e_i$ as follows.

The sum of the errors (relative to the mean error $\mu$) of current sources $2_1$ to $2_x$ connected to line A is:

$$E_A = \sum_{i=1}^{x}(e_i - \mu)$$

Similarly, the sum of the errors (relative to the mean error $\mu$) of current sources $2_{x+1}$ to $2_n$ connected to line B is:

$$E_B = \sum_{i=x+1}^{n}(e_i - \mu)$$

Thus, the transfer function E can be expressed as:

$$E = E_A - E_B$$

$$E = \sum_{i=1}^{x}e_i - x\mu - (\sum_{i=x+1}^{n}e_i - (n-x)\mu)$$

$$E = \sum_{i=1}^{x}e_i - \sum_{i=x+1}^{n}e_i + (n-2x)\mu$$

When x=0, all of the errors $e_1$ to $e_n$ are connected to line B which means that $E_A$ is zero. $E_B$ is also zero because by definition the sum of the line-B errors $e_1$ to $e_n$ is simply equal to n times the mean error $\mu$. Thus, E=0 as represented by point A in Fig. 5(B).

Similarly, when x=n, all of the errors $e_1$ to $e_n$ are connected to line A which means that $E_B$ is zero. $E_A$ is also zero because the sum of the line-A errors $e_1$ to $e_n$ is by definition $n\mu$. Thus, again E=0 as represented by point D in Fig. 5(B).

For all other values of x, the errors will be connected in different combinations to lines A and B with the result that the transfer function E is in the form of a "random walk" which always starts and ends at zero and can be positive, negative or zero at points in between.

When the input value changes from x-1 to x, the current source $2_x$ changes from being connected to line B to being connected to line A, increasing $E_A$ by $(e_x-\mu)$ and decreasing $E_B$ by $(e_x-\mu)$. Thus, each step in the random walk of the transfer function E is $2(e_x-\mu)$.

Accordingly, the transfer function E can be regarded as the accumulated current-source errors, relative to the mean current-source error, for the particular DAC device. Choosing to make E zero at x=0 and n is simply equivalent to choosing to draw a line L3 through the actual output-signal values at points A and D in Fig. 5(A).

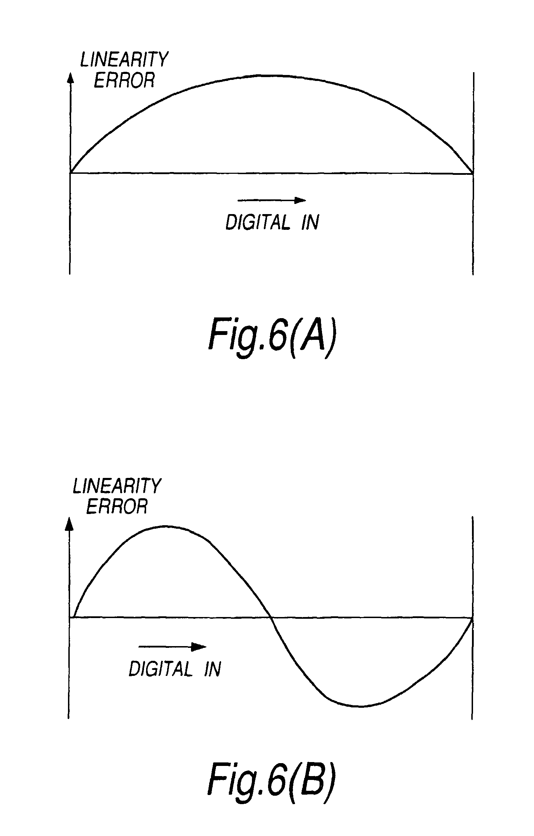

The transfer function causes unwanted distortion in the output of a DAC, to varying degrees and effects according to the exact shape of the transfer function. For example, a transfer function of the form shown in Fig. 6(A), which bows upwards (or downwards) in a single arc, will lead to the generation of unwanted second harmonics in the output signal. A transfer function of the form shown in Fig. 6(B), which is an S-shape passing through the zero-error axis at or near the mid-point, will lead to the generation of unwanted third harmonics in the output signal.

The current-source errors $e_i$ conform to a Gaussian (or normal) distribution. When DAC devices are manufactured the transfer functions E of the manufactured devices will also differ one from the next in accordance with the Gaussian distribution of current-source errors.

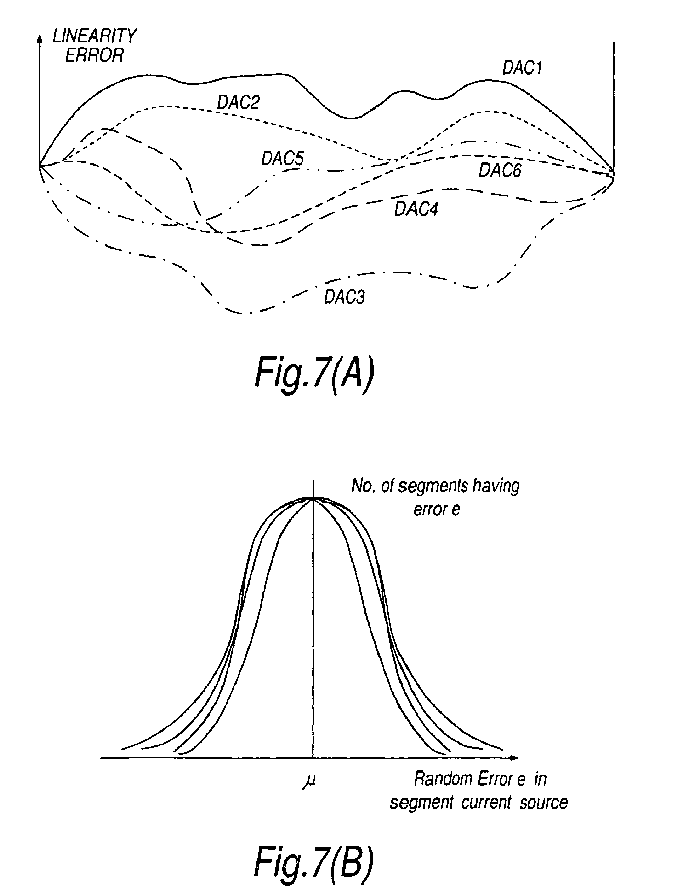

Fig. 7(A) of the accompanying drawings shows the transfer functions of six example DACs. In each individual DAC device the current source errors conform to a Gaussian distribution, and the current-source error distribution will be similar from one device to the next but with some deviation between devices, as shown in Fig. 7(B) of the accompanying drawings. The more segments there are in each device, the more similar the current source error distributions of different devices will be, but since the errors will be arranged (or selected) in a different order from one device to another, the transfer function of one device will almost always be different from that of another.

As a result of the fact that the transfer function differs from device to device, so too will the distortion in the output signal differ from device to device under the same input signal conditions. For example, for a DAC generating as its output signal a 100 MHz sine wave, the second harmonic would be a discrete tone at 200 MHz with a typical amplitude of, for example, -55dBc (i.e. -55dB relative to the main signal). However, since the transfer function is not the same from device to device as explained above, the amplitude of this second harmonic will typically vary from device to device by up to $\pm$10dB. Other distortion components caused by the non-linear output response of the device will also vary from device to device by a similar magnitude.

This device-to-device performance variation of several dB either side of typical has important consequences in terms of the manufacturing yield which can be achieved for the device.

From the point of view of the manufacturer of the devices, an assessment needs to be made of a trade-off between device yield and guaranteed minimum device performance (for example, a minimum signal-to-noise ratio in a particular frequency band of interest). Device-to-device performance variation means that the minimum performance must be specified as several dB worse than typical. One implication of this is that production testing and screening is required. Even allowing for some yield loss to reject the worst devices, the specification has to be reduced. Based on well-known device yield curves, it is known, for example, that if a guaranteed minimum noise performance figure is quoted based on a "mean-2σ" figure (produced by subtracting twice the standard deviation σ from the mean value), approximately 97% of manufactured devices will meet or exceed the guaranteed performance, i.e. the yield will be 97%.

If, instead of using a "mean-2σ" figure, the manufacturer quotes the guaranteed performance based on a more modest "mean-3σ" figure, the yield will increase to 99.9%, making the unit cost lower, but of course the quoted performance will also be lower, making the device less attractive to customers. If the manufacturer quotes the guaranteed performance based on a more demanding "mean-σ" figure, the yield will drop to approximately 84%, raising the unit cost, but the quoted performance will be higher, making the device more attractive to customers. The "mean-2σ" figure is often a sensible trade-off, in that it gives an attractive performance level for customers whilst keeping the yield desirably high so that the unit cost is economic.

It is therefore desirable from the manufacturer's point of view to reduce a device-to-device performance variation caused by differing transfer functions, so as to permit a better minimum performance to be specified by the manufacturer and/or an improved yield for a given minimum performance level.

EP-A-0898374 discloses mixed-signal circuitry, operative to perform a series of operation cycles, which may be considered to comprise: n circuitry segments which together produce an analog output signal; and control signal generating means operable in each said cycle to generate, in dependence upon a digital input signal, a set of n segment control signals for application to respective ones of the said segments to influence the produced analog output signal. The mixed-signal circuitry in this case is a DAC in which the current sources are arranged in first and second arrays. Each array contains cells arranged in 2 rows and 19 columns, of which 31 cells are most-significant bit (MSB) cells and the remaining cells are least-significant bit (LSB) cells and dummy cells. The MSB cells in each array are activated in a special order which is different from the physical order of the cells in the array, with one cell from the first array and an individually corresponding cell from the second array forming a pair of cells whose physical positions are mirror images or inverted mirror images of one another. The special activation order of the cells in each array does not vary with time. The cell pairing between the two arrays also does not vary with time.

Mixed-signal circuitry embodying a first aspect of the present invention is characterised by morphing means for causing the n segment control signals to be applied to the n segments in at least two different orders at different respective times, said orders being such that at least one order differs from the next order by more than a starting ordinal position amongst the segments and that the changes in ordinal position of the segments brought about by the changes in order of application of the segment control signals are limited in number and/or magnitude relative to said number n of segments.

According to a second aspect of the present invention there is provided a noise shaping method, for use in mixed-signal circuitry that is operative to perform a series of operation cycles and comprises n circuitry segments which together produce an analog output signal, said method comprising: in each said cycle generating, in dependence upon a digital input signal, a set of n segment control signals for application to respective ones of the said segments to influence the produced analog output signal; characterised by causing the n segment control signals to be applied to the n segments in at least two different orders at different respective times, said orders being such that at least one order differs from the next order by more than a starting ordinal position among the segments and that the changes in ordinal position of the segments brought about by the changes in order are limited in number and/or magnitude relative to said number n of the segments.

There are many different ways in which the number and/or magnitude of the ordinal position changes can be limited.

In terms of numbers of segments, in one embodiment, for each change in order there is at least one segment that is not changed in ordinal position. In another embodiment, for each change in order at least n/16 segments are not changed in ordinal position. In other embodiments, the numbers of segments changing are limited further still. For example, for each change in order at most n/2 segments may have a change in ordinal position, or at most a pair of segments may change ordinal position.

It is also possible to express the limitation in terms of an overall extent of the changes of ordinal position brought about by each change in order. For example, each change from one order to the next may be considered to have an associated segment change parameter, calculated by summing over all n segments the respective ordinal position changes, if any, brought about by the change in order concerned. The limits may then be expressed in terms of the values of the segment change parameters. In one embodiment the respective segment change parameters associated with the changes in order are each less than $n^2/4$, more preferably each less than or equal to 16n, and more preferably still each less than 2n. In another embodiment an average value of said segment change parameter per cycle is less than $n^2/64$, more preferably less than 16n, and more preferably still less than 2n. In another embodiment a difference between respective minimum and maximum values of the segment change parameter is limited relative to said number n of segments. For example, the difference may be less than $n^2/64$, more preferably less than 16n, and more preferably still less than 2n. It may even be zero.

In practice, to keep complexity down the order of application of the segment control signals to the segments in any one cycle is preferably selected from among a plurality of predetermined available orders. The total number of said predetermined available orders is preferably greater than 4, more preferably greater than n. The higher the number of available orders the greater the reduction in transfer function variation.

Each one of said predetermined available orders may be selected in turn in a predetermined order but preferably, to reduce the magnitudes of the noise components (whilst spreading them out), each one of the available orders is selected on a random or pseudo-random basis. In one embodiment, changes in order that involve more limited overall changes in ordinal position are caused to occur on average more often than changes in order that involve greater overall changes in ordinal position. This helps to keep a limit on the variation in value of the segment change parameter. In another embodiment the predetermined available orders are such that all changes in order involve approximately the same overall changes in ordinal position, i.e. approximately the same value of segment change parameter, and all changes in order are caused to take place on average with approximately the same frequencies.

One preferred way of changing the orders without making the circuitry too complex, and without the overall changes in ordinal position being too large, is swap the respective ordinal positions of segments belonging to one or more preselected pairs of segments.

An amount by which the noise components are spread out is influenced by an average time interval between repetitions of a given change in order. In one embodiment this average time interval is at least $0.1\mu$s.

The n segments may be sub-divided into m groups of segments, where m≥2. In one embodiment m=8 or 16 when n=128. When groups are formed the ordinal positions of segments belonging to the same group only may be changed, e.g. swapped. In this case, to limit the numbers of segments that change ordinal position changes in ordinal position may be permitted in m-1 or fewer of the m groups at any one time, for example in only one group at any one time. In order that segments can move to ordinal positions spanning over the range of n possible ordinal positions when the orders are changed, the ordinal positions of segments belonging to the same group are preferably spread out (e.g. evenly) over the range of n possible ordinal positions.

Reference will now be made, by way of example, to the accompanying drawings, in which:

Fig. 1, discussed hereinbefore, shows parts of a previously-considered current-steering DAC;
Fig. 2, also discussed hereinbefore, shows a table for use in explaining how thermometer-coded control signals are derived from a binary input word in the Fig. 1 DAC;
Fig. 3, also discussed hereinbefore, shows parts of cell array circuitry previously considered for use in a DAC;
Figs. 4(A) and 4(B), also discussed hereinbefore, are schematic diagrams for use in explaining the occurrence of graded and symmetrical errors in the cell array circuitry of Fig. 3;
Figs. 5(A) and 5(B), also discussed hereinbefore, are graphs for use in explaining the occurrence of random source errors in the cell array circuitry of Fig. 1 and Fig. 3;
Figs. 6(A) and 6(B), also discussed hereinbefore, show two example device transfer functions;
Figs. 7(A) and 7(B), also discussed hereinbefore, are graphs for use in explaining the variation in transfer function from device to device;
Fig. 8 is a block diagram for use in explaining operation of a DAC embodying the present invention;
Figs. 9(A), 9(B) and 9(C) are schematic diagrams illustrating the swapping of segments in an embodiment of the invention;
Figs. 10(A), 10(B) and 10(C) illustrate schematically transfer functions corresponding to the segment arrangements of Figs. 9(A), 9(B) and 9(C) respectively;
Fig. 11 is a table summarising the sequence of segment and random error orders illustrated with reference to Figs.

8 and 9;

Fig. 12 is a block diagram showing an example of a transfer function morphing section in one embodiment of the present invention;

Fig. 13 is a table showing the bits associated with eight unique local segment IDs;

Fig. 14 is a table showing the connection arrangement of a segment's local morphing ID inputs to a morphing ID signal bus according to the IDs of Fig. 13;

Fig. 15 is a table showing the bits associated with eight unique local segment IDs when subdivided into seven possible changes;

Fig. 16 is a table showing the connection arrangement of a segment's local morphing ID inputs to a morphing ID signal bus according to the IDs of Fig. 15;

Fig. 17 is a block diagram illustrating the division of segments into separate groups of segments;

Fig. 18 is a block diagram showing an example of a transfer function morphing section in another embodiment of the present invention;

Fig. 19 is a block diagram showing the constitution of one segment group shown in Fig. 18;

Fig. 20 is a block diagram showing the constitution of a group decoder shown in Fig. 19;

Figs. 21(A) and 21(B) are block diagrams showing in more detail the constitution of the group decoder of Fig. 19;

Fig. 22 is a block diagram showing the constitution of a segment decoder shown in Fig. 19;

Fig. 23 is a table showing the connection arrangement of a segment's local morphing ID inputs to a morphing ID signal bus;

Fig. 24 is a table showing how intermediate decode bits are produced from the morphing signal; and

Figs. 25(A), 25(B) and 25(C) are schematic diagrams illustrating rotation of segments.

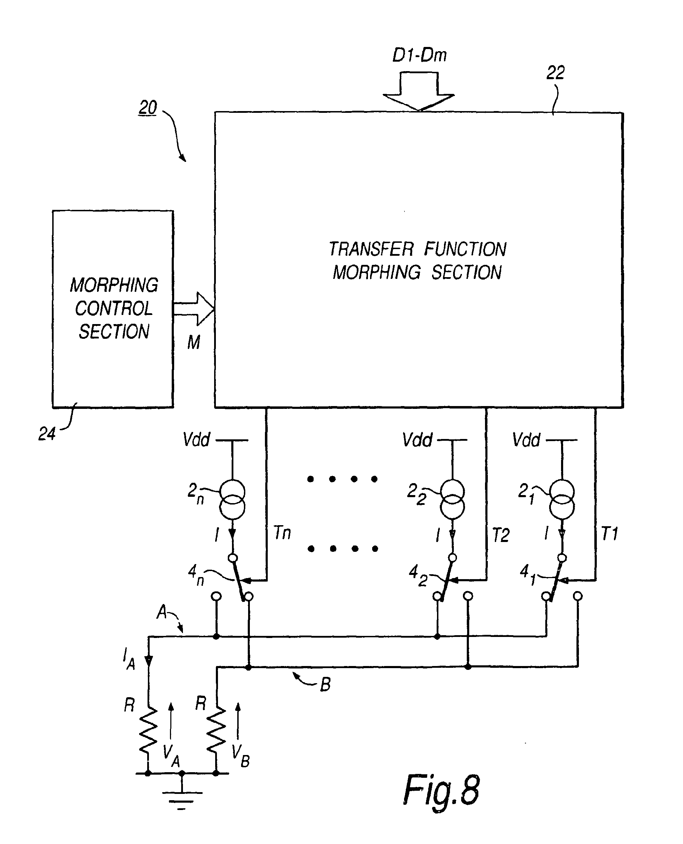

Fig. 8 is a block diagram for use in explaining in general terms the constitution and operation of a DAC embodying the present invention. More detailed specific embodiments will be described thereafter. Parts of the Fig. 8 DAC which are the same as, or correspond closely to, parts of the Fig. 1 DAC discussed hereinbefore are denoted by the same reference numerals, and a description of those parts is omitted.

The Fig. 8 DAC includes a digital circuitry portion DC and an analog circuitry portion AC. The analog circuitry portion AC is constituted in the same way as in the Fig. 1 DAC and includes a plurality of segments (or cells), each segment having a constant current source 2 and a switch 4. The switch 4 in each segment is controlled by an individually-corresponding thermometer-coded signal T supplied thereto from the digital circuitry portion DC.

In the Fig. 8 DAC, the digital circuitry portion DC includes a transfer function morphing section 22 and a morphing control section 24. The binary-thermometer decoder 6 of Fig. 1 is not necessary in this embodiment since its function is effectively incorporated into the transfer function morphing section 22, as will be described in more detail below.

The transfer function morphing section 22 has m inputs for receiving the binary input word D1-Dm and n outputs at which respective ones of the thermometer-coded output signals T1 to Tn of the digital circuitry portion DC are generated.

The transfer function morphing section 22 also has a control input connected to an output of the morphing control section 24 for receiving therefrom a morphing control signal M.

Operation of the Fig. 8 DAC will now be described. The DAC performs a series of operation cycles (conversion cycles) at a predetermined operating frequency (sampling rate) $F_{DAC}$. $F_{DAC}$ is, for example, 100 million samples per second (100Msamples/s).

In each cycle, the transfer function morphing section 22 receives the morphing control signal M to be used in that cycle and converts the externally-applied input word D1-Dm into the n thermometer-coded signals (segment control signals) T1 to Tn in accordance with the received signal M.

The operation of the transfer function morphing section 22 and the morphing control section 24 will now be described with reference to an illustrative example in which the DAC has only 8 segments so as to simplify the explanation.

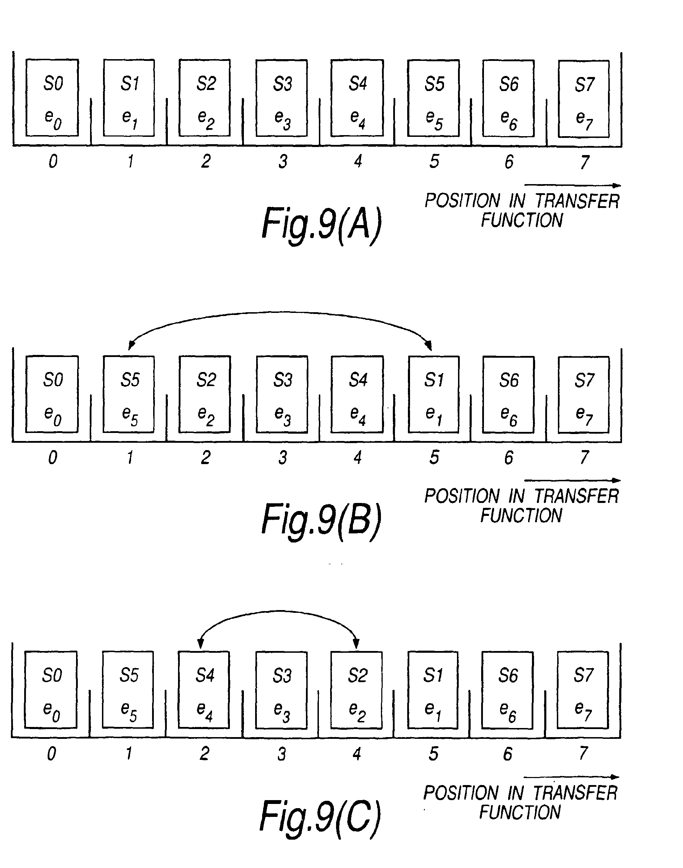

Fig. 9(A) is a schematic diagram showing the set of eight segments S0 to S7, with each segment being constituted as described above with reference to Fig. 8. The current source 2 within each segment $S_L$ generates a current I having a random current source error $e_i$ associated with it, so that segment Si generates a current of $(I+e_i)$. Shown within each segment of Fig. 9(A) are the segment number and the random current source error associated with that segment.

In the Fig. 8 DAC, as in the conventional DAC of Fig. 1, as the binary input word is increased, the segments are switched over progressively from line B to line A in order, i.e. the differential switch $4_i$ in that segment switches the current $(I+e_i)$ from line B to line A. However, in the Fig. 8 DAC the order of the segments can be changed at predetermined time intervals, for example every conversion cycle, by the transfer function morphing section 22 so that in one conversion cycle the segments switch over in a first predetermined order and in another conversion cycle the segments switch over in a second predetermined order different from the first order.

The segment order is controlled by the morphing control section 24 by applying the morphing control signals to the transfer function morphing section 22. The morphing signal M can, for example, be an indication of the absolute order to be used, or it can be an indication of how the order is to change relative to the previous conversion cycle. In each conversion cycle, the transfer function morphing section 22 then decodes the received binary input word (digital input signal) D1-Dm and applies the thermometer-coded output signals T1 to Tn to the differential switches 4 in accordance with the morphing control signal M so as to arrange the segments in the order indicated by that signal.

As described in the introduction, the corresponding respective random source errors $e_0$, $e_1$, $e_2$, $e_3$, $e_4$, $e_5$, $e_6$ and $e_7$ influence the transfer function (non-linearity error) according to the order in which they are arranged to switch over.

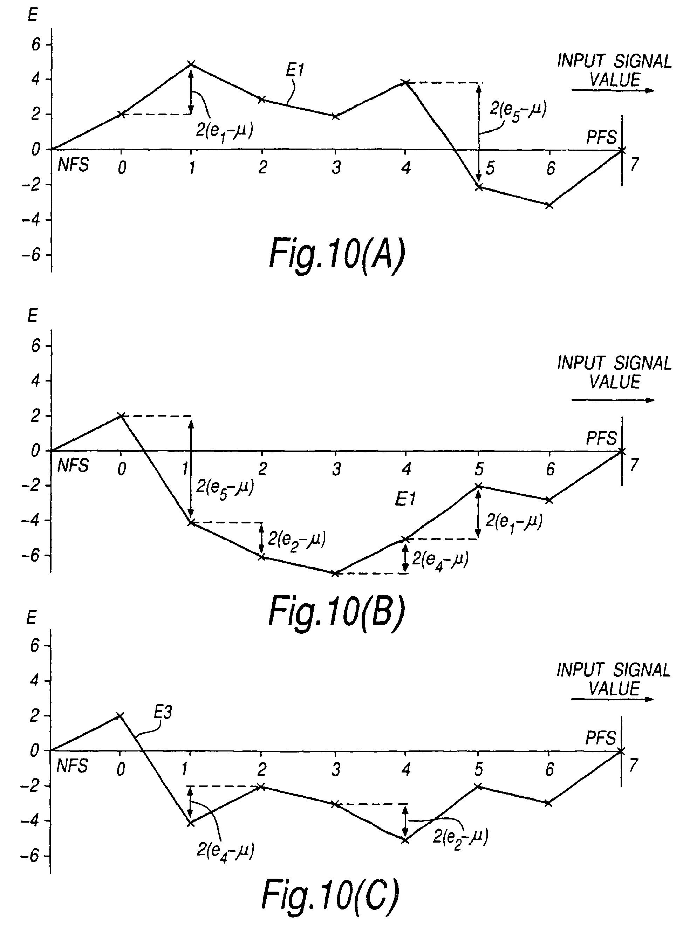

Initially, as shown in Fig. 9(A) itself, the segments are initially in the order S0, S1, S2, S3, S4, S5, S6 and finally S7. The transfer function E resulting from the initial segment order shown in Fig. 9(A) is schematically illustrated by line E1 in Fig. 10(A). In this example the magnitudes of the illustrated errors $e_0$ to $e_7$ relative to the mean error $\mu$ are assumed to be as follows: $e_0=\mu+1$, $e_1=\mu+1.5$, $e_2=\mu-1$, $e_3=\mu-0.5$, $e_4=\mu+1$, $e_5=\mu-3$, $e_6=\mu-0.5$ and $e_7=\mu+1.5$. As can be seen from Fig. 10(A), as the input signal value increases from negative full scale (NFS) to positive full scale (PFS) the segments are switched over in order, the accumulated error (transfer function) steps up or down by an amount according to twice the random current- source error (relative to the mean error $\mu$) associated with the segment being switched over, so that when, for example, segment S1 is switched over the transfer function changes by $2(e_1-\mu)$ (a rise of 3 in this example). When segment S5 is switched over, the transfer function changes by $2(e_5-\mu)$ (a fall of 6 in this example).

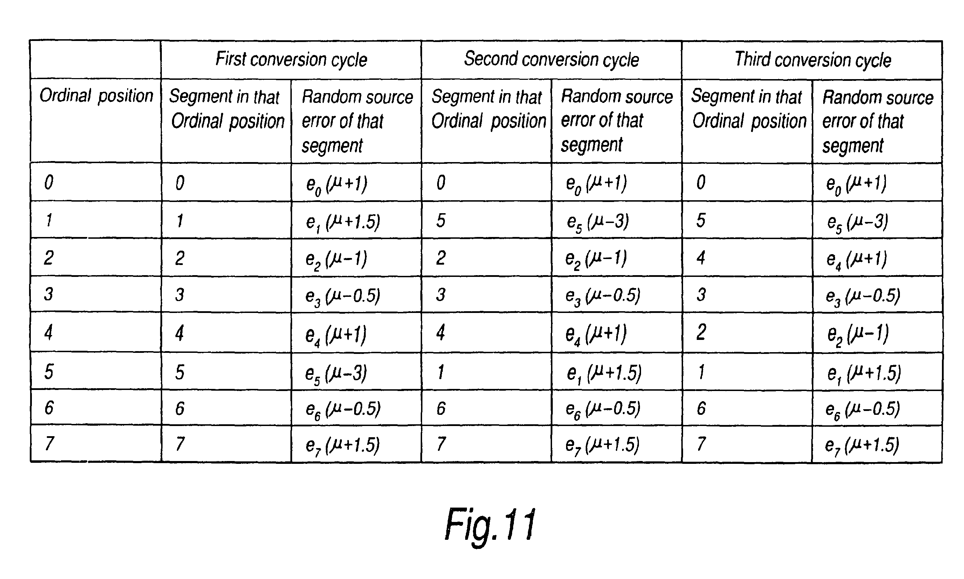

The order of segments for the first cycle of this illustrative example is summarised in the first of the two columns entitled "First conversion cycle" in the table of Fig. 11.

In this example, before the next conversion cycle the morphing control section 24 sends a morphing control signal M indicating that, compared to their ordinal positions in the original order, segments S1 and S5 are to be swapped so that the segments are switched in a new order (second order) as illustrated in Fig. 9(B). This has the effect of changing the order in which the random source errors are selected, as shown in the first of the two columns entitled "Second conversion cycle" in the table of Fig. 11. The change in the order of selection of the random source errors results in a different "random walk" of the accumulated error (transfer function E), as illustrated by line E2 in Fig. 10(B). In the second conversion cycle, the large negative source error of segment S5 ($e_5=\mu-3$) is applied much earlier in the range of input values than in the previous cycle, resulting in a profile which looks substantially different, dipping below zero early on and remaining negative for the rest of the input value range. In this regard, the transfer function E2 of the DAC in the second cycle is similar to the form of transfer function described above with reference to Fig. 6(A), whereas the transfer function E1 of the DAC in the first cycle is more similar to that described above with reference to Fig. 6(B).

Finally, in the third conversion cycle the morphing control section 24 sends a morphing control signal M indicating that, compared to their segment positions in the second order, segments S2 and S4 are to be swapped as illustrated in Fig. 9(C). This again has the effect of changing the order in which the random source errors are selected, as shown in the first of the two columns entitled "Third conversion cycle" in the table of Fig. 11, resulting in the transfer function illustrated schematically by line E3 in Fig. 10(C).

Although the three transfer functions E1 to E3 illustrated in Figs. 10(A) to 10(C) relate to the same device in three different respective cycles, they could alternatively be considered as relating to three different respective DACs, each having the same distribution of random source errors but arranged in a different order. The above-described swapping of segment orders has the effect of "morphing" the transfer function of a single DAC from one shape to another.

Consider two separate DACs having eight segments with the same set of random source errors associated with their segments, but laid out in a different physical order on the chip. With no morphing being performed as described above, the transfer functions of the two devices will be different. For example, suppose that the first device has the set of random source errors selected in the order shown in Fig. 9(A), and the second device has the same set of random source errors selected in the different order shown in Fig. 9(B). The first device will have a transfer function of the form shown in Fig. 10(A), whilst the second device will have a transfer function of the form shown in Fig. 10(B). Since, as mentioned above, the transfer function of the first DAC is similar to the form of transfer function described above with reference to Fig. 6(B), while the transfer function of the second DAC is more similar to that described above with reference to Fig. 6(A), it may be expected that the second DAC will exhibit greater second harmonic distortion than the first DAC.

By performing the above-described "morphing" operations in each device such that the segments are arranged over time in two or more different orders in each DAC, the transfer function of the DAC will change over time to have two or more different forms. As a result, each DAC has an effective transfer function dependent on an average of the two or more different forms. Because of this averaging, the two DACs will tend to have more similar distortion performances. The higher the number of different segment orders used the greater the convergence of the distortion performances.

The transfer function morphing technique has been described illustratively above with reference to Figs. 9(A) to (C) and 10(A) to (C) in relation to the current source mismatches which are inevitably present in a real DAC. These current source mismatches contribute in each conversion cycle to an error in the amplitude of (and hence distortion in) the output signal. In fact, the segments also have time delay mismatches associated with them, in addition to the current amplitude mismatches. These delay mismatch errors can be considered to alter the shape of the transfer function by contributing to a horizontal (rather than vertical) deviation in the points on the transfer function. The morphing technique is also effective in reducing the distortion due to these delay mismatches (which tend to become more significant as the sampling frequency increases).

When the number of segments is as small as eight, the distribution of random source errors will actually vary significantly from device to device. As a result, for two selected devices it is unlikely that the same set of current source errors will be present as just described, so that the morphing operation will not in general make the effective transfer functions look entirely the same.

However, since the errors are drawn from a Gaussian distribution, as the number of segments in the devices increases, the distributions of the source errors in different devices will become progressively more similar. This is because, in statistical theory, if a parent population has a mean $\mu$ and a standard deviation $\sigma$, then the sample means constitute a population with mean $\mu$ and standard deviation $\sigma/\sqrt{n}$ of approximately Gaussian form (for large n), and the sample variances constitute a population with mean $\{(n-1)/n\}\sigma^2$. Therefore, when n is large, the distributions converge.

As a result, when the number of segments is large (e.g. more than 16, and preferably 128 or more), and the transfer function in each of the devices is morphed through many different forms in that device (e.g. more than 16, and preferably n or more), the overall effective transfer functions of different devices can be made to look very similar. This has the effect of reducing the performance variation from device to device, which as mentioned above is desirable to achieve in view of the effect it has on improving the manufacturing yield of the device for a given minimum performance requirement or improving the guaranteed minimum performance for given yield. For example, if the transfer function is morphed over 128 different forms then a particular distortion component exhibiting a device-to-device variation before morphing of $\pm10$dB can be expected to exhibit a device-to-device variation after morphing of approximately $1/\sqrt{128}$ times that variation, or $\pm1$dB.

Note that this effect is different to the rotation technique and the "magic square" technique described above. When the segment selection order is rotated from cycle to cycle, this has the effect of shifting the starting-point along the transfer function (starting ordinal position of the segments), whilst still selecting the errors in the same order and hence keeping the same overall transfer function profile of the device. Each device will still, therefore, have a different transfer function to that of another device. In the "magic square" technique, the segments are always selected in the same order, albeit different to the physical order on which they are laid down on the chip, so that the transfer function of a particular device is static and will vary from device to device.

The effect of morphing is to take discrete distortion components (e.g. harmonic distortion) which vary from device to device (e.g. by $\pm10$dB) and change those components into a narrowband noise-like signal at the same frequency, but with a much smaller variation from device to device. The remaining variation will depend upon the number of segments and the manner in which they are reordered, but will typically be at least 10 times smaller. For example, for a DAC generating a 100 MHz sine wave, the second harmonic would be a discrete tone at 200 MHz with a typical amplitude of, for example, -55dBc (i.e. -55dB relative to the main signal), but with a range of -45dBc to -65dBc across different devices. If the effective transfer function is morphed through many possible forms over a 1 $\mu$s period, then the second harmonic will appear as noise at about 200 MHz with a spread in frequency (i.e. the $\pm3$db points) of approximately $\pm\{1/(1\ \mu s)\}$ or $\pm1$MHz and an energy of -55dBc typical, with a range of, for example, -54dBc to -56dBc over all devices.

The transfer function should preferably be changed relatively slowly because the transfer function is being modulated, which causes the distortion components to spread out in frequency. If the rate of change of the transfer function is too high then these can spread into a desired signal band. If the rate of change is too slow then the instantaneous distortion will simply be seen changing slowly over time. A rate of change in between these two extremes is therefore desirable. Large step changes in the transfer function are also undesirable since these would cause sudden jumps in the output signal, which in turn cause wideband noise.

Slow morphing differs from changing the transfer function rapidly and/or by large steps, even if only occasionally, (for example, by employing segment shuffling in which, say, the segments are shuffled quadrant-by-quadrant in the array of Fig. 3) which turns distortion into wideband noise, because slow morphing only spreads the distortion out into a narrow band.

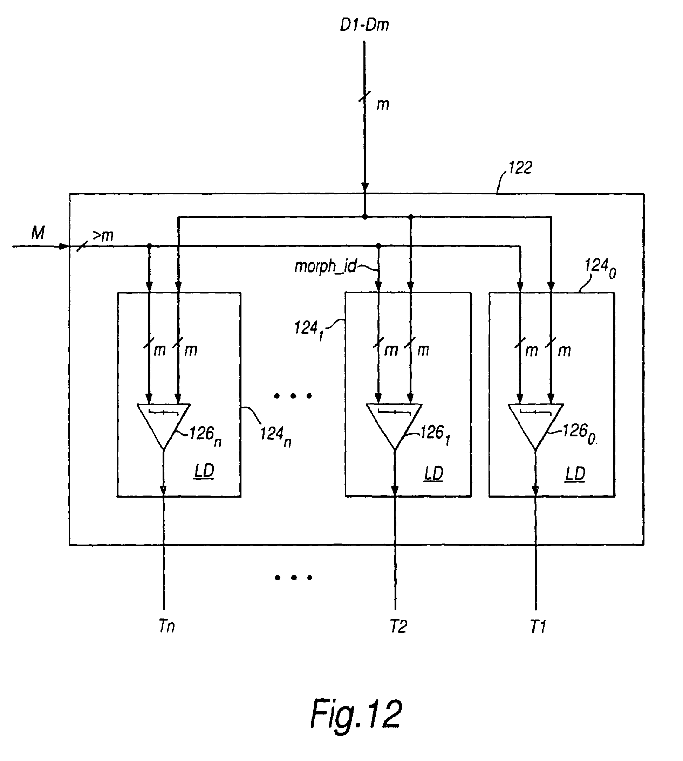

There will now be described with reference to Fig. 12 one possible constitution of the transfer function morphing section 22 described above with reference to Fig. 8.

The transfer function morphing section 122 of Fig. 12 comprises eight local decoders $124_0$ to $124_7$. Each local decoder 124 has two inputs, the first for receiving the morphing control signal M described above with reference to Fig. 8, and the second for receiving the binary input word D1-Dm. Each local decoder outputs one of the n thermometer-coded signals (segment control signals) T1 to Tn shown in Fig. 8.

Each local decoder 124 comprises a comparator 126 having two inputs. The comparator 126 receives at its two inputs the binary input word D1-Dm applied to the second input of the local decoder and a morph_id signal containing certain bits, different for each local decoder, selected from the morphing control signal as will be described below, and outputs a thermometer-coded signal T for its segment.

Operation of the example DAC having a transfer function morphing section 122 as shown in Fig. 12 will now be described. In this example it will be assumed that the number n of segments is 8 for the sake of simplicity, but it will be appreciated that with suitable modifications the concept can readily be applied to a DAC having more than 8 segments. In this example, since there are 8 segments, the binary input word D1-Dm is 3 bits wide, as are the morph_id signals mentioned above.

As can be seen from a comparison of Fig. 12 with that of Fig. 1, in this example the decoding of the binary input word D1-Dm into thermometer-coded signals T1-Tn is not done "globally" (by a centralised binary-to-thermometer decoder such as the decoder 6 in Fig. 1) but instead is performed locally within each of the n segments, as will be described in detail now.

Each of the 8 segments is assigned a unique ID (local ID) chosen from one of the values 0 to 7 (according to the morph_id signal applied to the segment), and this unique ID is compared by the comparator 126 with the binary input word D1-Dm to determine the state of the differential switch 4 for the segment concerned. In this example, if the binary input word is greater than the ID, then the output of the comparator (T) is high (1), which causes the switch 4 to connect the current source 2 to line A (hereinafter the "ON" state).

When such a greater-than comparator 264 is used in each of the 8 segments as described above, one of the segments (the segment for which ID = 7) is always in the OFF state (T=0) in any cycle, since the binary input word can never be greater than 7. To maintain a zero offset (taking into account the differential current-switching nature of the switching circuitry), an extra "dummy" segment is included which is maintained to be always in the ON state (T=1). This is more convenient than using only 7 segments. If a greater-than-or-equal comparison were instead performed by the comparator, then one of the segments (the segment for which ID = 0) would always be in the ON state (T=1), so that the extra "dummy" segment would instead need to be maintained in the OFF state (T=0) to achieve a zero offset.

As mentioned above, the segments have IDs in the range from 0 to 7. Therefore each segment whose ID is less than the binary input word will have its thermometer-coded signal T set to 1. All other segments will have their thermometer-coded signals set to 0. In this example, therefore, the set of comparators 126 performs the same basic function as the binary-thermometer decoder 6 of the Fig. 1 DAC.

With this arrangement, it is now possible easily to change the order of segment selection (segment ordinal positions) simply by changing the ID assigned to each segment using the morph_id signal.

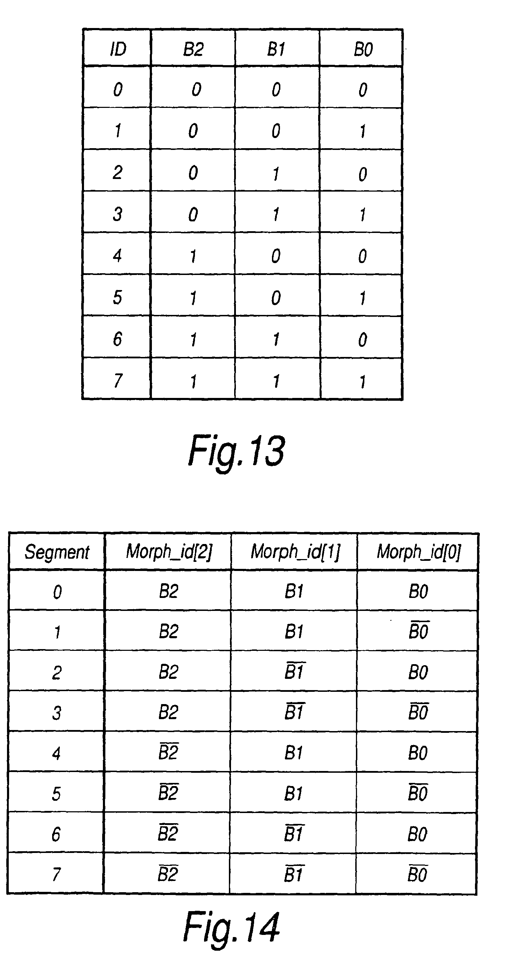

With changeable local IDs, it must be ensured that at any one time each of the eight local decoders 126 has allocated to it a unique ID, chosen from the set as shown in the table in Fig. 13. Each ID is a three-bit binary number having bits labelled (from least to most significant) B0, B1 and B2. One way to ensure that each local decoder has a different ID allocated to it is to maintain and change a single 3-bit master code, and to route these 3 bits, plus their respective inverses, to the local decoders. These six bits form the morphing control signal M. Each local decoder then picks off just three of these six bits to form its own morph_id signal.

The table of Fig. 14 shows one way in which the six bits of the morphing control signal M can be used by the local decoder for each of the eight segments. For example, morph_id for segment 0 is a three-bit word comprising the bits (B2,B1,B0) in order from most to least significant, while morph_id for segment 5 is a three-bit word comprising the bits ($\overline{B2}$,B1, $\overline{B0}$) in order from most to least significant. When the master code has, for example, the value 011, then morph_id for segment 0 is 011 whilst morph_id for segment 5 is 110. In this way it is ensured that the morph_id input to each local decoder is unique. It also makes changing the local IDs of the segments simple, since it is only necessary to update the 3-bit master code.

Incidentally, although it is described above that the 3 bits plus their inverses (making a total of 6 bits) are routed to each local decoder 126, it is of course possible to distribute only the three bits themselves without their inverses and to provide inverters in the appropriate local decoders to generate the inverse signal locally. However, this would have the undesirable result that the circuitry of each local decoder would not be the same.

The order of selection of the segments can be changed from cycle to cycle in a variety of ways depending on how the master 3-bit code is updated. If the master code is simply incremented every cycle (wrapping around to 000 after 111) then the segment order is rotated. This would not create the desired effect of transfer function morphing since, as indicated above, rotation does not alter the basic shape of the transfer function but simply changes the starting position along it.

To achieve morphing, the binary state of one of the three bits B0, B1, and B2 of the master code can be changed from one cycle to the next. This has the effect, when the segments are considered arranged at different respective positions in order of their IDs, of swapping various pairs of segments at certain positions in that order. For example, if the state of bit B0 is changed, then the segments at the following positions are swapped:

$$0<=>1$$

$$2<=>3$$

4<=>5

6<=>7

The distance moved by both of the segments in a pair (change in position) is 1, with four pairs being swapped at once, so the total effective move is 8. This total effective move can be used to define a segment change parameter (SCP) associated with each change in order. It is calculated by summing over all n segments the changes in ordinal positions, if any, of the segments brought about by the change in order. It serves as a measure of the overall change in ordinal position brought about by the change in order.

If the state of bit B1 is changed, then the segments at the following positions are swapped:

0<=>2

1<=>3

4<=>6

5<=>7

In this case, the distance moved by both of the segments in a pair is 2, with four pairs being swapped at once, so the total effective move (SCP) is 16.

If the state of bit B2 is changed, then the segments at the following positions are swapped:

0<=>4

1<=>5

2<=>6

3<=>7

In this case, the distance moved by both of the segments in a pair is 4, with four pairs being swapped at once, so the total effective move (SCP) is 32.

If one of these three updates is chosen at random each time, then the average total effective move per conversion cycle (average SCP per cycle) is

```
(change*probability) = 8*(1/3) + 16*(1/3) + 32*(1/3) =
56/3 = 18.67.
```

The total effective move (segment change parameter) is reflected in the overall change to the transfer function for each change. As mentioned above, it is desirable that the transfer function is morphed slowly from one state to another and does not make too many large changes at once. This can be achieved by limiting the average changes in ordinal position of the segments, brought about by the changes in order, in number and/or magnitude relative to the total number n of segments. This is equivalent to limiting the SCP value relative to n. Also, the difference between the maximum and minimum SCP values is preferably limited relative to n. For example, in this case the maximum and minimum SCP values are 8 and 32, so that the difference (24) is 3n. Exemplary values are given in the examples that follow.

In view of the fact that in the present example a change to bit B2 causes a comparatively large overall change of 32 (4n), it is preferable that B2 is changed least often.

One way to achieve this is to update the master code each time according to the Gray-scale code, i.e. in the following manner: 000->001->011->010->110->111- >101->100->101->111 etc. In this case, B2 is changed twice over 16 cycles, whilst B1 is changed four times and B0 is changed eight times, so that the average move per conversion cycle is now (change*probability) = 32*(2/16) + 16*(4/16) + 8*(8/16) = 192/16 = 12 (i.e. the average SCP is limited to 1.5n in this case).

However, in this case a limited set of transfer functions is repeated at regular intervals. In this case, the same sequence of transfer functions would be repeated every 16 conversion cycles, giving a repeat frequency of ($F_{CLK}$/16), where $F_{CLK}$ is the frequency of the conversion cycles, which has the effect of generating discrete sidebands at this spacing.

In the above-mentioned method in which the binary state of a random one of the bits B0, B1, and B2 is changed per cycle, a change to bit B2 causes four pairs of segments to move a distance of four segments all at once. To limit the total effective move (SCP) to a total of 8 segments it is possible to split this B2 change into four separate changes, with only one change being made at any one time, i.e. (0<=>4), (1<=>5), (2<=>6), or (3<=>7). In the same way, the B1 change may be limited to an total effective move (SCP) of 8 segments by splitting it into two possible changes, for example (0<=>2 & 4<=>6) or (1<=>3 & 5<=>7). The B0 change already causes an total effective move of eight, so there is only one possible choice: (0<=>1 & 2<=>3 & 4<=>5 & 6<=>7).

These seven possible changes are labelled for convenience as follows:

B0: (0<=>1 & 2<=>3 & 4<=>5 & 6<=>7)
B1a: (0<=>2 & 4<=>6)
B1b: (1<=>3 & 5<=>7)
B2a: (0<=>4)
B2b: (1<=>5)
B2c: (2<=>6)
B2d: (3<=>7)

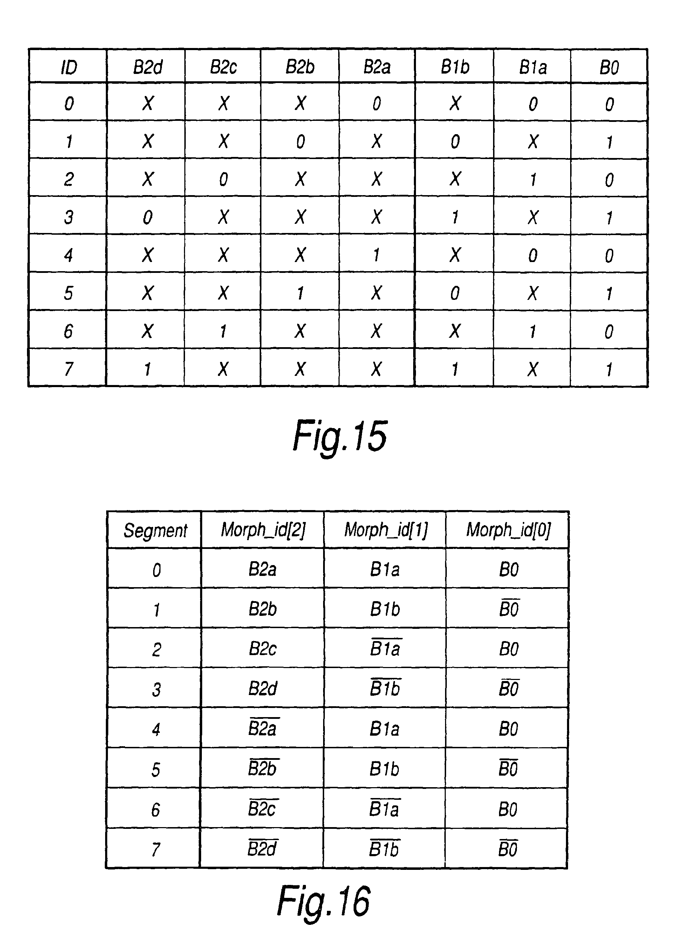

This can be implemented by maintaining and updating a seven-bit master code (rather than a three-bit master code as before), with each of the above seven possible changes being achieved by swapping the bit value of a corresponding one of the seven bits. In order to achieve this, the local IDs correspond to this seven-bit master code as shown in the table of Fig. 15. Comparing this table to that in Fig. 13, it can be seen that the B2 column of Fig. 13 has been split into four columns B2a, B2b, B2c and B2d, corresponding respectively to the four changes labelled B2a, B2b, B2c and B2d mentioned above, with each column containing only one pair of opposite binary values at the two positions of the pair of segments required to be swapped when those binary values are reversed. Similarly, the B1 column has been split into two columns B1a and B1b, corresponding respectively to the two changes labelled B1a and B1b mentioned above, with each column containing only two pairs of opposite binary values at the four positions of the two pairs of segments required to be swapped when those binary values are reversed. The B0 column of Fig. 15 is the same as that of Fig. 13.

The morphing control signal M now has a total of 14 bits (the seven bits B0, B1a, B1b, B2a, B2b, B2c, B2d and their inverses) to be distributed to the local decoders 126. Since each local decoder requires only a three-bit morph_ id, it picks off three of the bits from the morphing signal M according to the table shown in Fig. 16.

In this example, the morphing control section 24 is responsible for swapping one of the seven bits of the morphing signal M at random each cycle, and the average move per conversion cycle (average SCP) is now 8 (n), compared to the average of 18.67 without the splitting of the higher-order bits B1 and B2.

This random selection of one of seven possible choices is preferably implemented by generating a random 3-bit number which selects one of the seven changes to make. Since this random 3-bit number actually has eight states, two of them are preferably made to select the change represented by swapping bit B0.

As mentioned above, in the transfer function morphing section 122 described above with reference to Fig. 12, the decoding of the binary input word D1-Dm into thermometer-coded signals T1-Tn is not done "globally" (by a centralised binary-to-thermometer decoder such as the decoder 6 in Fig. 1) but instead is performed locally within each of the n segments. It will be appreciated that it is also possible to implement the transfer function morphing section 22 of Fig. 8 in other different ways, for example by first generating a set of thermometer-coded signals using a binary-to-thermometer decoder such as the decoder 6 in Fig. 1, and then re-ordering these thermometer-coded signals (using, for example, a barrel shifter), to produce the segment control signals T1-Tn.

To achieve the lowest device-to-device variation, the order of selection of the segments in a DAC should ideally be changed gradually through every possible order so that as many different forms of transfer functions are traversed over the course of time. In practice, however, the overall complexity of the circuitry (for example, in terms of the gate count) required to achieve this for a large number of segments can be prohibitive. In view of this, a sensible compromise must be made between increased complexity of the circuitry on the one hand and restricting the total number of segment orders that can be covered (and therefore the amount by which device-to-device variation can be reduce by morphing) on the other hand.

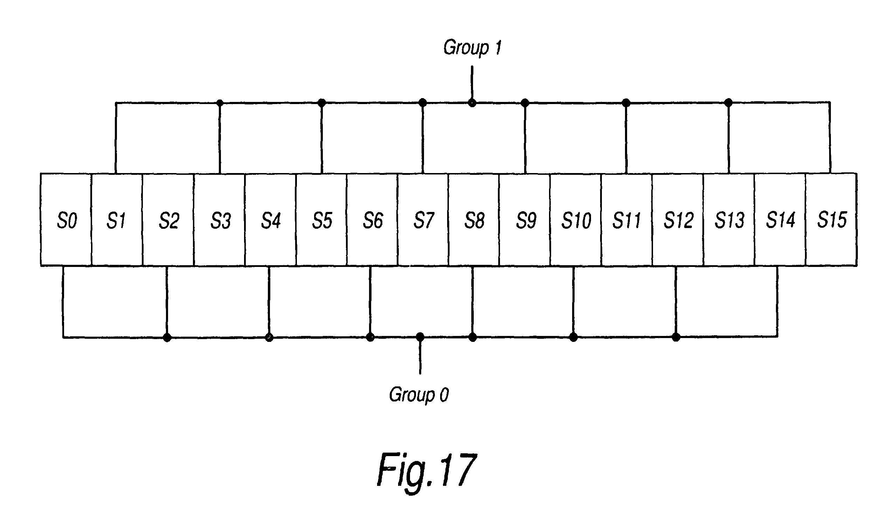

One possible compromise is to divide the segments into a number of groups, and to swap the segments only within an individual group. By further arranging for the segments within each group to be spread evenly across the entire transfer function, it is possible still to achieve good morphing performance whilst reducing the overall circuit complexity considerably. For example, Fig. 17 shows an example in which a total of 16 segment S0 to S15 are divided into two groups "Group 0" and "Group 1" comprising 8 segments each: (S0, S2, S4, S6, S8, S10, S12, S14) in Group 0 and (S1, S3, S5, S7, S9, S11, S13, S15) in Group 1. The illustrated positions of these segments are in relation to the transfer function (order of selection) and not necessarily their physical positions on the chip. Therefore it is possible (and preferable) to arrange for all the segments in one group to be situated close to each other on the chip, even though they are actually spread across the transfer function. Segments in one group are never swapped with the segments in another group.

The choice of the number of groups is another compromise. Larger groups give more linearity improvement (matching between different DACs), but smaller groups give less wideband noise because fewer segments change position location every clock cycle.

In the examples described above with reference to Figs. 12 to 16, there were a total of 8 segments addressed by a 3-bit binary data input word D1-Dm. The local decoder in each segment had a 3-bit local ID which was compared to the 3-bit binary data input word D1-Dm to derive the thermometer-coded signals T1-Tn. In addition, the local IDs associated with each segment were made to swap around in various ways so that the segment order was continually changing. The arrangements of Figs. 12 to 16 can easily be modified to a more practical DAC in which there are 128 segments, as will now be described.

The 128 segments can be divided into 16 groups of 8 segments, as follows:

```
group 0 = segments (0, 16 ... 96, 112)
group 1 = segments (1, 17 ... 97, 113)
...
group 14 = segments (14, 30 ... 110, 126)
group 15 = segments (15, 31 ... 111, 127)
```

With this arrangement, each member of a group is separated by a distance of 16 segments in the transfer function from its neighbouring member of the group, and the members of each group are spread evenly across the transfer function. Each group has 4 ID bits to all members of the group common (the four least significant bits) which are fixed and different for each group, and 3 ID bits (the three most significant bits) which are different for each member of the group.

Since there are 128 segments in the DAC to be addressed, a seven-bit data word input D1-Dm is required, and the local decoder of each segment has a seven-bit local ID. The four least significant bits of this seven-bit local ID for members of a particular group can be hard-wired to a 4-bit combination unique to that group, whilst each member in the group can select three different bits from a 14-bit morphing signal bus as described above to provide the three most significant bits of the local ID for that member. Changing the master code will now swap members around within a group, but will not swap members belonging to different respective groups.

In order to reduce the total number of swaps performed (or SCP) per conversion cycle, it is also preferable that only one group is swapped for each cycle. This can be achieved by generating a four-bit random number which selects one of the groups to be active in a particular conversion cycle. The morphing control signal M then acts to swap members of the active group in that cycle.

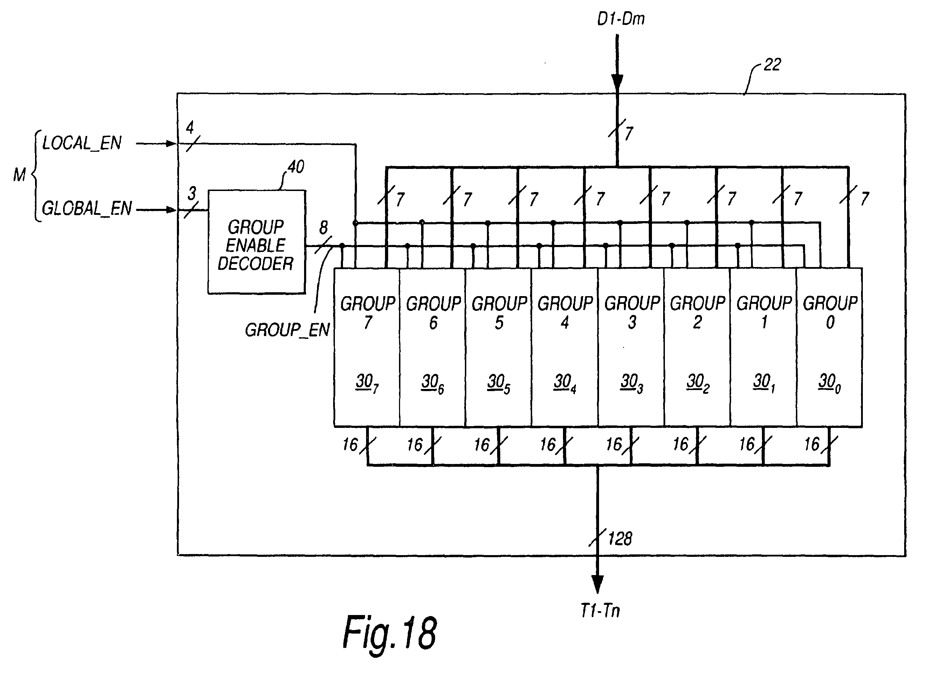

Fig. 18 shows the constitution of the transfer function morphing section 22 of Fig. 8 in another preferred embodiment of the present invention in which there are a total of 128 segments divided into 8 groups of 16 segments each, as follows:

```
group 0 = segments (0, 8 ... 112, 120)
group 1 = segments (1, 9 ... 113, 121)
...
group 6 = segments (6, 14 ... 118, 126)
group 7 = segments (7, 15 ... 119, 127)
```

With this arrangement, each member of a group is separated by a distance of 8 segments in the transfer function from its neighbouring member of the group, and the members of each group are spread evenly across the transfer function.

The transfer function morphing section 22 of Fig. 18 comprises a group enable decoder 8, and eight segment groups $30_0$ to $30_7$. The transfer function morphing section 22 has inputs for receiving the seven-bit binary input word D1-Dm, a four-bit "local_en" signal and a three-bit "global_en" signal. The "local_en" signal and a three-bit "global_en" signal together comprise the morphing control signal M described above with reference to Fig. 8. Each segment group 30 outputs 16 of the 128 thermometer-coded outputs T1-Tn. The group enable decoder 8 has an input for receiving the global_en signal and an output for outputting an 8-bit group_en signal. Each segment group 30 has an input for receiving a predetermined one of the bits of the 8-bit group en signal, an input for receiving the local_en signal, and an input for receiving the binary input data word D1-Dm.

The local_en signal and the global_en signals are generated every conversion cycle by the morphing control section 24 shown in Fig. 8. The global_en signal is a 3 bit random number which selects one of the eight segment groups $30_0$ to $30_7$ to have its segment members swapped for that particular conversion cycle. The segments in all non-selected segment groups retain their segment ordering from the previous cycle. The group enable decoder 40 decodes this three-bit global_en signal to produce a 1-of-N eight-bit group_en signal, with a different one of the group_en bits being set to 1 for each different value of the three-bit global_en signal (all the remaining group_en bits are set to 0). The eight bits of group_en signal are applied to different respective ones of the eight segment groups $30_0$ to $30_7$.

The local_en signal generated by the morphing control section 24 is a four-bit random number which selects one of 15 possible segment swaps to perform on segments in the segment group 30 selected in that conversion cycle. Since the local_en signal has 16 different states, two of them select the same one of the 15 possible segment swaps. This will be described in more detail below.

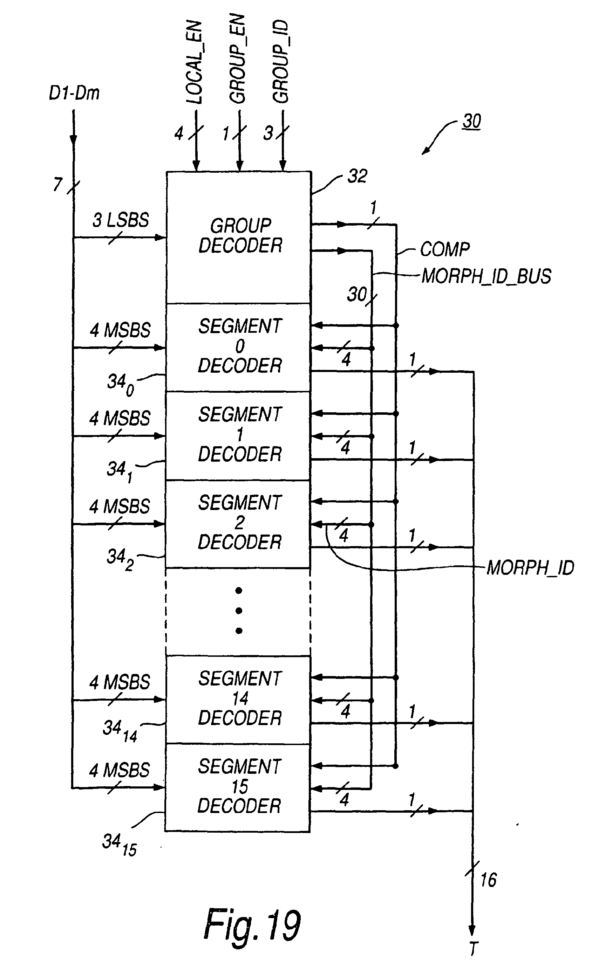

Fig. 19 shows the constitution of the segment groups $30_0$ to $30_7$ in more detail. Each segment group 30 comprises 16 segment decoders $34_0$ to $34_{15}$ and a single group decoder 32 shared in common between all of the segment decoders $34_0$ to $34_{15}$. The group decoder 32 has inputs for receiving the local_en and group_en signals described above, and an input for receiving the three least significant bits of the binary input data word D1-Dm. The group decoder 32 also has an input for receiving a three-bit group_id signal which represents the three least significant bits of the local ID of all of the 16 segments in the group. The group decoder 32 also has a single-bit "comp" output and a 30-bit morph_id_bus output. Each segment decoder 34 has an input for receiving the four most significant bits of the binary input data word D1-Dm, further inputs for receiving the comp signal and selected bits of the morph_id_bus signal output from the group decoder 32, and a single-bit output at which one of the thermometer-coded output signals T is output.

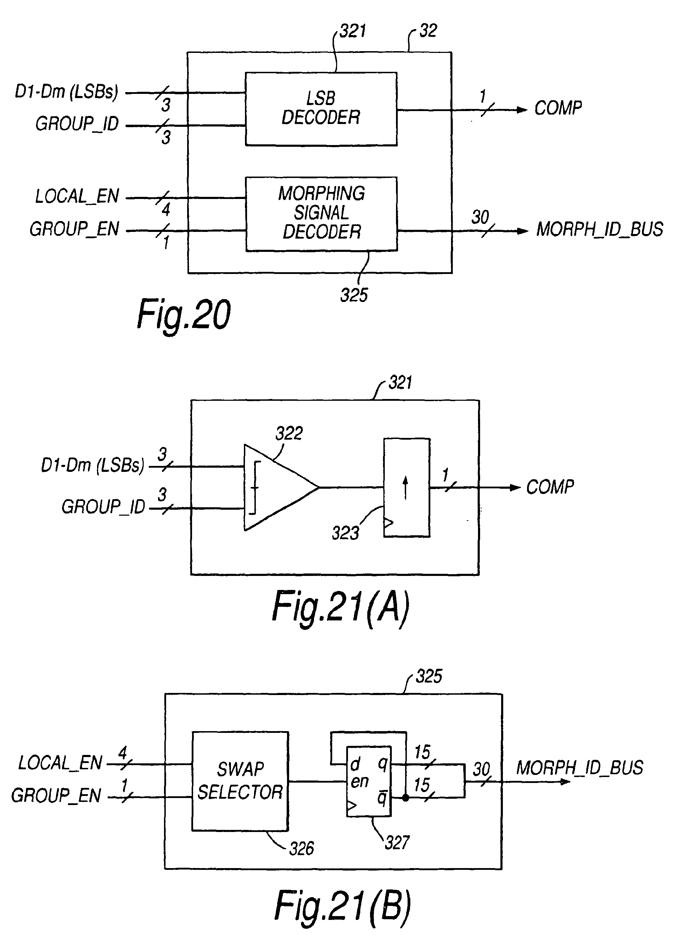

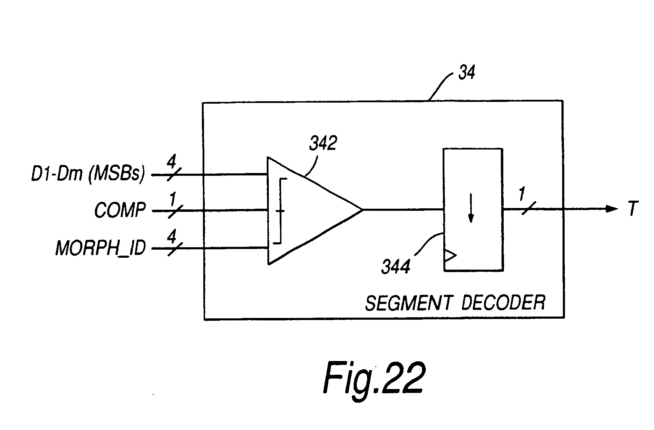

The constitution and operation of the group decoder 32 and the segment decoders 34 will now be described in more detail with reference to Figs. 20 to 22. The group decoder 32 comprises an LSB decoder 321, shown in more detail in Fig. 21(A), and a morphing signal decoder 325, shown in more detail in Fig. 21(B). The LSB decoder 321 comprises a comparator 322 and a latch 323, whilst the morphing signal decoder 325 comprises a swap selector 326 and a set of D-type flip-flops 327. Each segment decoder 34 comprises a comparator 342 and a latch 344.

The comparator 322 in the LSB decoder 321 compares the three least significant bits of the binary input word D1-Dm with the unique three-bit group ID "group_id" for that group. The result of this comparison is latched by latch 323 and output as signal "comp" and passed to the comparator 342 in each of the segment decoders $34_0$ to $34_{15}$. The comparator 342 in the segment decoder 34 then performs a similar operation on the most significant bits, comparing the four most significant bits of the binary input word D1-Dm with the four-bit "morph_id" for that segment, making use of the result "comp" of the comparison of the least significant bits. The result of the comparison performed in a segment decoder 34 represents the thermometer-coded output signal T which controls the differential switch 4 for that segment.

In the example described above with reference to Fig. 12, in which the segments were not divided up into groups, the comparator 126 in each of the local decoders 124 compared all m bits of the binary input word D1-Dm with all m bits of the morph_id signal. In this example, the operations performed by the local decoder are split into operations on the least significant bits, performed by the LSB decoder 321 in the group decoder 32, and operations on the most significant bits, performed by the segment decoder 34. The LSB decoder 321 makes use only of the three least significant bits of the binary input word D1-Dm, and the three least significant bits (group_id) of the segment ID. The segment decoder 34 makes use of the four most significant bits of the binary input word D1-Dm, and the four most significant bits (morph_id) of the segment ID. A carry bit "comp" is required to be communicated from the least significant bit comparator 322 to the most significant bit comparator 342.

It will be appreciated that this two-stage comparison process is not essential. It could be arranged that a single seven-bit comparison is performed for each segment, with the four most significant bits being comprised of the morph_id bits and the three least significant bits being comprised of the group_id bits in common to all the segments in a group. However, it is preferable that a two-stage process is used since the circuitry for the comparison of the three least significant bits can be shared between all segments in a group, requiring only a four-bit comparator to be provided in each of the segment decoders. In addition, a two-stage process allows the operations performed by the local decoder to be pipelined, with operations from one conversion cycle overlapping with operations from an adjacent cycle, as is discussed in detail in our co-pending European patent publication no. EP-A-1100203.

The process of generating the four most significant bits of each segment's ID (or morph_id) will now be described with reference to Fig. 21(B), 23 and 24. As mentioned above, the local_en signal received by the morphing signal decoder 325 from the morphing control section 24 is a four-bit random number which selects one of 15 possible segment swaps to perform on segments in the segment group 30 selected in that conversion cycle by the random group selection signal group_en. For the example described above with reference to Fig. 12 in which there were only 8 segments in a group, one of seven possible swaps was chosen at random by a three-bit random number and achieved by swapping the binary state of one of the bits of a seven-bit master code. A function equivalent to this is performed by the morphing signal decoder 325 in the present example.

In this case, there are 16 segments in a group requiring a four-bit morph_id. If the swapping is effected by way of changing the binary state of one of bits B3, B2, B1 and B0 of a four-bit master code, then the following swaps would occur:

    B0: (02468ACE) <=> (13579BDF)
    B1: (014589CD) <=> (2367ABEF)
    B2: (012389AB) <=> (4567CDEF)
    B3: (01234567) <=> (89ABCDEF)

Here, the members of each group are denoted in hexadecimal notation as members 0, 1, 2, ..., 9, A, B, C, D, E, F. For example, in group 0 member 0 is segment 0, member 1 is segment 8, member E is segment 112 and member F is segment 120.

The total distance moved by the members within a group for each of the above swaps is 16, 32, 64 and 128 for swaps B0, B1, B2 and B3 respectively. Since each member of a group is actually separated by 8 segments from a neighbouring member, this represents an average total effective move (SCP) of 128 (n), 256 (2n), 512 (4n) and 1024 (8n) segments respectively. In order to limit the total change caused to the transfer function, the above changes are split into the following sub-choices in a similar way as described above:

    B0: (02468ACE) <=> (13579BDF)
    B1a: (048C) <=> (26AE)
    B1b: (159D) <=> (37BF)
    B2a: (08) <=> (4C)
    B2b: (19) <=> (5D)
    B2c: (2A) <=> (6E)
    B2d: (3B) <=> (7F)
    B3a: (0) <=> (8)
    B3b: (1) <=> (9)
    B3c: (2) <=> (A)
    B3d: (3) <=> (B)
    B3e: (4) <=> (C)
    B3f: (5) <=> (D)
    B3g: (6) <=> (E)
    B3h: (7) <=> (F)

The total change for each of these choices is a move of 16 members. As each member is separated by 8 segments, the total effective move (SCP) for any change is 16 x 8 segments, i.e. 128 segments. Thus, in this case the average SCP per cycle is limited to n.

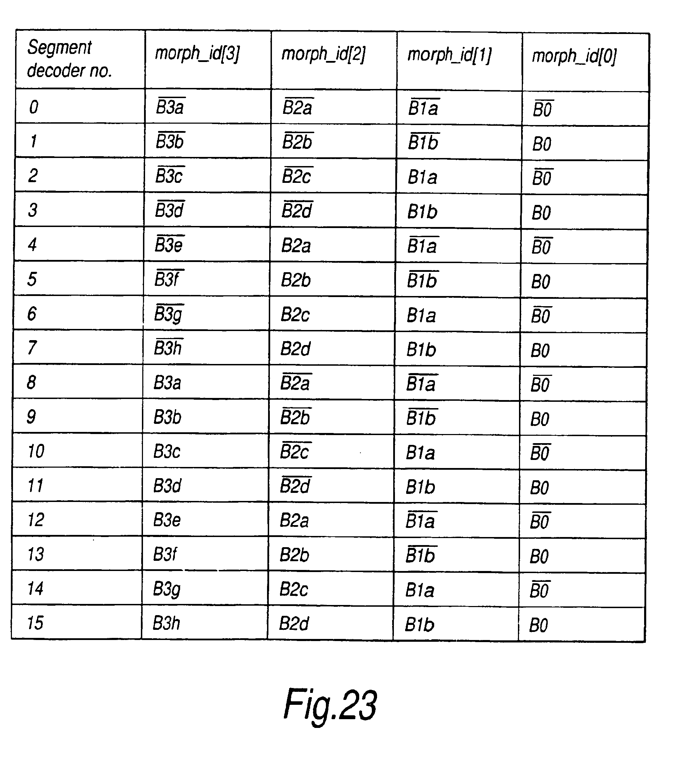

The master code described above which is updated every conversion cycle is represented in this example by the 15 Q outputs of the set of 15 D-type flip-flops 327 in Fig. 21(B). The 15 $\bar{Q}$ outputs together with the 15 Q outputs form the 30-bit morph_id_bus signal which is fed to the segment decoders 34. Each segment decoder uses an unique set of four bits from the morph_id_bus signal to form its own four-bit morph_id signal as summarised in the table of Fig. 23.

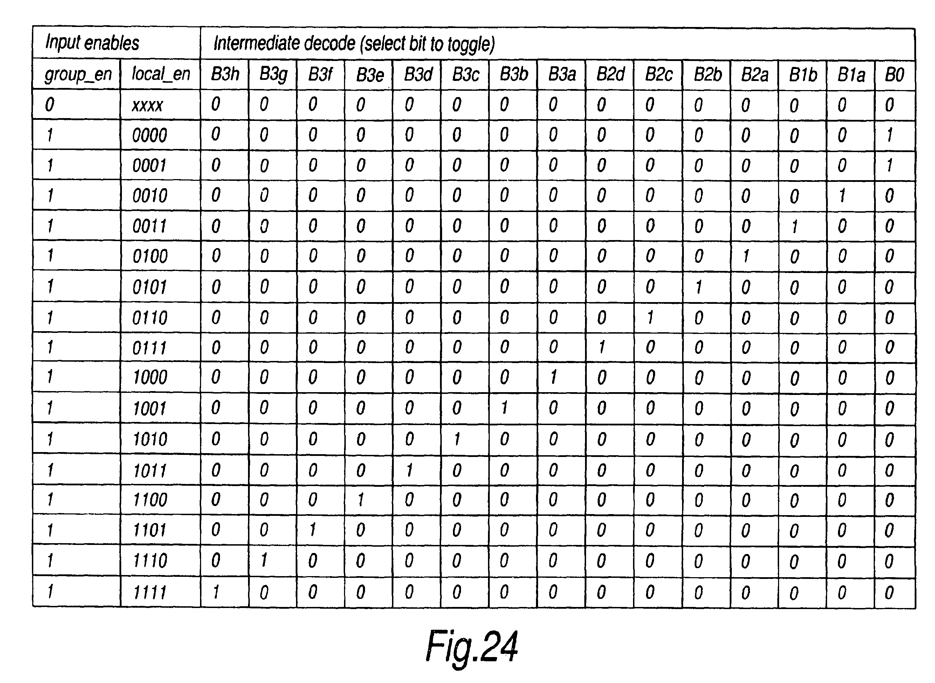

The four-bit local_en signal selects one of the above 15 swaps to make in a particular conversion cycle. The swap is only made if the group_en signal is high for that particular group in that cycle. Since the local_en signal has 16 different states, two of them select the same one of the 15 possible segment swaps. The swap selector 326 in the morphing signal decoder 325 generates a 1-of-N 15-bit intermediate decode signal according to the table shown in Fig. 24, with the high bit selecting one of the bits to swap. In this example, the swap "B0" is activated for local_en values of both 0000 and 0001. No swap is performed when group_en is set to 0.

The $\bar{Q}$ outputs of the set of D-type flip-flops 327 are fed back as respective D inputs to the flip-flops. This causes the outputs to toggle each time the flip-flop is clocked. However, since only one flip-flop is enabled by the intermediate decode signals, only one bit of the 15-bit master code is toggled each conversion cycle.

With 16 groups of 8 possible swaps each (or equivalently 8 groups of 16 possible swaps), it takes an interval of (on average) 128 clock cycles for a given swap to be repeated. This has the effect of turning each distortion component into noise spread over a band of about $\pm(F_{CLK}/128)$, so that each noise band is about 10 MHz wide (or $\pm5$ MHz) at 624 Ms/s. By choosing $F_{CLK}$ and the average swap repetition interval appropriately, the noise bands centred on each distortion component can be confined in size so that they do not extend into the wanted signal band.

In one embodiment the noise spreading is actually half this, so that each noise band is about 5MHz wide (or $\pm2.5$ MHz) at 624 Ms/s. This is achieved because the DAC is provided with two blocks of decoder circuitry, one being an "odd" block used to decode the input signal in odd-numbered conversion cycles and the other being an "even" block used to decode the input signal in even-numbered conversion cycles. Thus, each "odd" and "even" block is clocked at half the DAC update rate, as described in more detail in our co-pending United Kingdom patent publication no. GB-A-2356301.

As mentioned above in relation to the use of a Gray-code updating method, if the same set of transfer functions is repeated every 16 cycles, this has the effect of generating discrete sidebands at a spacing of $(F_{CLK}/16)$. However, if the set of transfer functions changes as well, then the noise is spread over approximately this bandwidth. If the noise bandwidth spread is too large then the rate at which segments are swapped can be reduced so that the morphing happens more slowly. The segment order does not have to be changed every cycle, so that in some cycles (e.g. alternate cycles) it can be arranged that there is no change in segment order.

The choice of using 8 groups of 16 segments instead of 16 groups of 8 segments is partly driven by layout considerations. Each group is laid out as a row of 16 members, with the group logic at one end. Since the whole block is duplicated for "odd" and "even" logic, this layout amounts to a 16x16 array, with the common logic between the two groups. Each member (local decoder, about 200 gates) is approximately square (since that is the best shape for minimising interconnect) so the top-level layout is approximately square.

The above-described morphing technique can also be used in combination with the segment rotation technique described in detail in our co-pending European patent publication no. EP-A-1100203, the entire content of which is incorporated herein by reference.

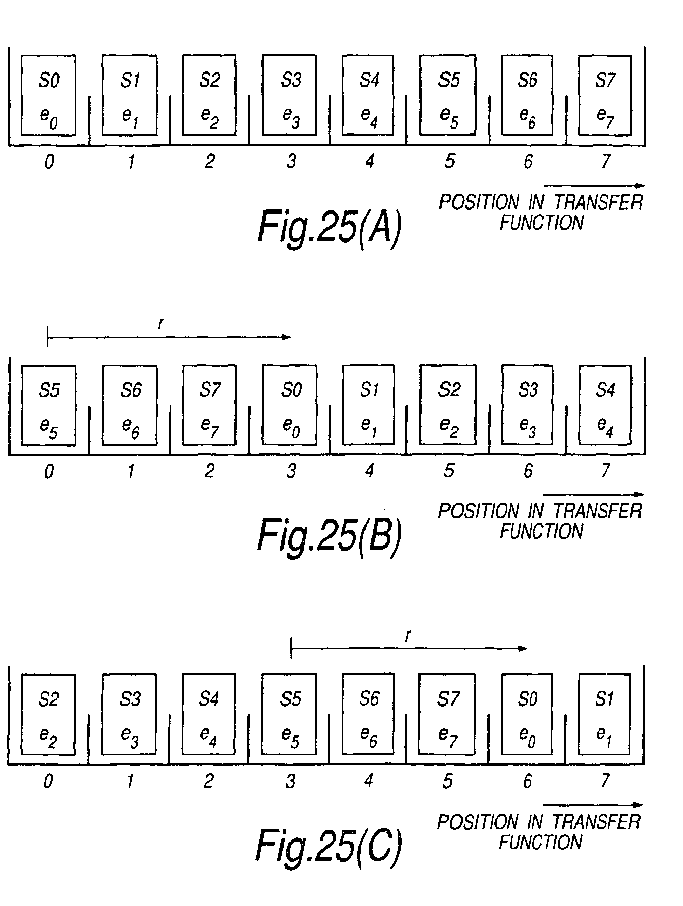

As illustrated schematically in Figs. 25(A) to (C), in the rotation technique, the segments are rotated each conversion cycle by a certain number r of segments (rotation amount). For example, the segment ordering of Fig. 25(A) has been rotated by an amount r of three segments, with segments wrapping around from the end back to the beginning. A further rotation of three segments brings the segment ordering to that shown in Fig. 25(C). This has the effect of shifting the starting position in the transfer function without actually altering the shape of the transfer function.

The facility for segment rotation can easily be included in the morphing circuitry described above with reference to Figs. 18 to 24 by adding in each conversion cycle a rotation amount r to the segment's complete local ID, made up by a combination of the group_id and morph_id associated with the segment. This can be achieved by adding the three least significant bits of the rotation amount r to the group_id value before the comparison operation is performed by the comparator 322 in the LSB decoder 325 of the group decoder 32, and adding the four most significant bits of the rotation amount r to the morph_id value before comparison by the comparator 342 in the segment decoders 34. The carry bit from the least significant bit adder would also be communicated to the most significant bit adder.

When morphing is applied in combination with rotation, the morphing removes the device-to-device variation still present after rotation and also removes the discrete tones in the spectrum caused by the rotation. This previously required the use of random spreading of the rotation amount which is no longer necessary when morphing is used, although this can still be used to improve the smoothness of the noise floor.

Taking the example of a GSM communication system, where the channels are spaced apart by 100-200 kHz, it is desirable to spread the noise by at least the width of one channel. The spreading should also be small enough that the distortion components generated by the rotation do not spread significantly away from their intended positions, which are typically at least 5 MHz away from the band of interest. The spreading caused by morphing is typically of the order of $\pm 2.5$ MHz, so that the rotation components do not spread into the band of interest.

It will be appreciated that the present invention is also applicable to mixed-signal circuitry which does not produce a differential output signal. Instead of switching over its current from one line to another, each segment may simply switch its current on or off or change its magnitude in some other way according to the digital input signal.

**Claims**

1.  Mixed-signal circuitry, operative to perform a series of operation cycles, comprising:

    n circuitry segments ($2_1,4_1$ to $2_n,4_n$) which together produce an analog output signal ($I_A$-$I_B$); and
    control signal generating means (22) operable in each said cycle to generate, in dependence upon a digital input signal (D1-Dm), a set of n segment control signals (T1-Tn) for application to respective ones of the said segments to influence the produced analog output signal;

    **characterised by** morphing means (24) for causing the n segment control signals to be applied to the n segments in at least two different orders at different respective times, said orders being such that at least one order differs from the next order by more than a starting ordinal position amongst the segments and that the changes in ordinal position of the segments brought about by the changes in order of application of the segment control signals are limited in number and/or magnitude relative to said number n of segments.

2.  Circuitry as claimed in claim 1, wherein for each change in order there is at least one segment that is not changed in ordinal position.

3.  Circuitry as claimed in claim 1, wherein for each change in order at least n/16 segments are not changed in ordinal position.

4.  Circuitry as claimed in claim 1, wherein for each change in order at most n/2 segments have a change in ordinal position.

5.  Circuitry as claimed in claim 1, wherein for each change in order at most a pair of segments change ordinal position.

6.  Circuitry as claimed in any preceding claim, wherein each change from one order to the next has an associated segment change parameter, calculated by summing over all n segments the respective ordinal position changes, if any, brought about by the change in order concerned, and the respective segment change parameters associated with the changes in order are each less than $n^2/4$.

7.  Circuitry as claimed in any one of claims 1 to 5, wherein each change from one order to the next has an associated segment change parameter (SCP), calculated by summing over all n segments the respective ordinal position changes, if any, brought about by the change in order concerned, and the respective segment change parameters associated with the changes in order are each less than or equal to 16n.

8.  Circuitry as claimed in any one of claims 1 to 5, wherein each change from one order to the next has an associated segment change parameter (SCP), calculated by summing over all n segments the respective ordinal position changes, if any, brought about by the change in order concerned, and the respective segment change parameters associated with the changes in order are each less than 2n.

9.  Circuitry as claimed in any one of claims 1 to 8, wherein each change from one order to the next has an associated segment change parameter (SCP), calculated by summing over all n segments the respective ordinal position changes, if any, brought about by the change in order concerned, and an average value of said segment change parameter per cycle is less than $n^2/64$.

10. Circuitry as claimed in any one of claims 1 to 8, wherein each change from one order to the next has an associated segment change parameter (SCP), calculated by summing over all n segments the respective ordinal position changes, if any, brought about by the change in order concerned, and an average value of said segment change parameter per cycle is less than 16n.

11. Circuitry as claimed in any one of claims 1 to 8, wherein each change from one order to the next has an associated segment change parameter (SCP), calculated by summing over all n segments the respective ordinal position changes, if any, brought about by the change in order concerned, and an average value of said segment change parameter per cycle is less than 2n.

12. Circuitry as claimed in any preceding claim, wherein each change from one order to the next has an associated segment change parameter (SCP), calculated by summing over all n segments the respective ordinal position changes, if any, brought about by the change in order concerned, and a difference between respective minimum and maximum values of the segment change parameter is limited relative to said number n of segments.

13. Circuitry as claimed in any preceding claim, wherein the said morphing means are operable to cause the order of application of said segment control signals to said segments in any one cycle to be selected from among a plurality of predetermined available orders.

14. Circuitry as claimed in claim 13, wherein a total number of said predetermined available orders is greater than 4.

15. Circuitry as claimed in claim 13, wherein a total number of said predetermined available orders is greater than or equal to said number n of segments.

16. Circuitry as claimed in claim 13, 14 or 15, wherein each one of said predetermined available orders is selected on a random or pseudo-random basis.

17. Circuitry as claimed in any one of claims 13 to 15, wherein changes in order that involve more limited overall changes in ordinal position are caused to occur on average more often than changes in order that involve greater overall changes in ordinal position.

18. Circuitry as claimed in any one of claims 13 to 16, wherein the said predetermined available orders are such that all changes in order involve approximately the same overall changes in ordinal position, and all changes in order are caused to take place on average with approximately the same frequencies.

19. Circuitry as claimed in any preceding claim, wherein the said changes in order involve swapping the respective ordinal positions of segments belonging to one or more preselected pairs of segments.

20. Circuitry as claimed in any preceding claim, wherein an average time interval between repetitions of a given change in order is at least $0.1\mu s$.

21. Circuitry as claimed in any preceding claim, wherein the said morphing means are operable to subdivide the n segments into m groups of segments, where $m \geq 2$, and are operable to change the ordinal positions of segments belonging to the same group.

22. Circuitry as claimed in claim 21, wherein changes in ordinal position are permitted by the said morphing means in m-1 or fewer of said m groups at any one time.

23. Circuitry as claimed in claim 21, wherein changes in ordinal position are permitted by the said morphing means in only one group at any one time.

24. Circuitry as claimed in claim 21, 22 or 23, wherein n=128 and m=8 or 16.

25. Circuitry as claimed in any one of claims 21 to 24, wherein the ordinal positions of segments belonging to the same group are spread out over the range of n possible ordinal positions.

26. Circuitry as claimed in any preceding claim, having a decoder circuit (124) corresponding to each segment and connected for receiving said digital input signal and an ID signal (M), and operable to set a logic state of the segment control signal applied to its corresponding segment in dependence upon the result of a comparison between said digital input signal and said ID signal;
said morphing means being operable to cause the respective ID signals received by the decoder circuits of different segments to change to bring about said changes in order.

27. Circuitry as claimed in claim 26 when read as appended to any one of claims 21 to 25, wherein parts (32) of the decoder circuits corresponding to segments belonging to the same group of segments are shared.

**28.** Circuitry as claimed in any preceding claim further comprising segment rotating means operable in each said cycle to rotate the said ordinal positions by r segments as compared to the preceding cycle, where r is a rotation amount set for the cycle concerned.

**29.** A noise shaping method, for use in mixed-signal circuitry that is operative to perform a series of operation cycles and comprises n circuitry segments ($2_1,4_1$ to $2_n,4_n$) which together produce an analog output signal ($I_A$-$I_B$), said method comprising:

in each said cycle generating, in dependence upon a digital input signal (D1-Dm), a set of n segment control signals (T1-Tn) for application to respective ones of the said segments to influence the produced analog output signal;

**characterised by** causing the n segment control signals to be applied to the n segments in at least two different orders at different respective times, said orders being such that at least one order differs from the next order by more than a starting ordinal position among the segments and that the changes in ordinal position of the segments brought about by the changes in order of application of the segment control signals are limited in number and/or magnitude relative to said number n of the segments.

**Patentansprüche**

**1.** Mischsignalschaltungsanordnung, die operativ ist, um eine Serie von Operationszyklen auszuführen, mit:

n Schaltungsanordnungssegmenten ($2_1$, $4_1$ bis $2_n$, $4_n$), die zusammen ein analoges Ausgangssignal ($I_A$-$I_B$) hervorbringen; und
einem Steuersignalerzeugungsmittel (22), das in jedem genannten Zyklus betriebsfähig ist, um in Abhängigkeit von einem digitalen Eingangssignal (D1-Dm) einen Satz von n Segmentsteuersignalen (T1-Tn) zur Anwendung auf jeweilige der genannten Segmente zu erzeugen, um das hervorgebrachte analoge Ausgangssignal zu beeinflussen;
**gekennzeichnet durch** ein Morphing-Mittel (24), zum Bewirken, daß die n Segmentsteuersignale auf die n Segmente in wenigstens zwei verschiedenen Ordnungen zu jeweiligen verschiedenen Zeiten angewendet werden, wobei die Ordnungen so sind, daß sich wenigstens eine Ordnung von der nächsten Ordnung **durch** mehr als eine Startordinalposition unter den Segmenten unterscheidet und daß die Veränderungen der Ordinalposition der Segmente, die **durch** die Veränderungen der Anwendungsordnung der Segmentsteuersignale herbeigeführt werden, in der Zahl und/oder der Größe bezüglich der Anzahl n von Segmenten begrenzt sind.

**2.** Schaltungsanordnung nach Anspruch 1, bei der es bei jeder Ordnungsveränderung wenigstens ein Segment gibt, dessen Ordinalposition nicht verändert wird.

**3.** Schaltungsanordnung nach Anspruch 1, bei der bei jeder Ordnungsveränderung bei wenigstens n/16 Segmenten die Ordinalposition nicht verändert wird.

**4.** Schaltungsanordnung nach Anspruch 1, bei der bei jeder Ordnungsveränderung bei höchstens n/2 Segmenten die Ordinalposition verändert wird.

**5.** Schaltungsanordnung nach Anspruch 1, bei der bei jeder Ordnungsveränderung bei höchstens einem Paar von Segmenten die Ordinalposition verändert wird.

**6.** Schaltungsanordnung nach irgendeinem vorhergehenden Anspruch, bei der jede Veränderung von einer Ordnung in die nächste einen zugeordneten Segmentveränderungsparameter hat, der berechnet wird, indem bei allen n Segmenten die jeweiligen Ordinalpositionsveränderungen, falls vorhanden, die durch die betreffende Ordnungsveränderung herbeigeführt werden, summiert werden, und die jeweiligen Segmentveränderungsparameter, die den Ordnungsveränderungen zugeordnet sind, jeweils kleiner als $n^2/4$ sind.

**7.** Schaltungsanordnung nach irgendeinem der Ansprüche 1 bis 5, bei der jede Veränderung von einer Ordnung in die nächste einen zugeordneten Segmentveränderungsparameter (SCP) hat, der berechnet wird, indem bei allen n Segmenten die jeweiligen Ordinalpositionsveränderungen, falls vorhanden, die durch die betreffende Ordnungsveränderung herbeigeführt werden, summiert werden, und die jeweiligen Segmentveränderungsparameter, die den Ordnungsveränderungen zugeordnet sind, jeweils kleiner gleich 16n sind.

8. Schaltungsanordnung nach irgendeinem der Ansprüche 1 bis 5, bei der jede Veränderung von einer Ordnung in die nächste einen zugeordneten Segmentveränderungsparameter (SCP) hat, der berechnet wird, indem bei allen n Segmenten die jeweiligen Ordinalpositionsveränderungen, falls vorhanden, die durch die betreffende Ordnungsveränderung herbeigeführt werden, summiert werden, und die jeweiligen Segmentveränderungsparameter, die den Ordnungsveränderungen zugeordnet sind, jeweils kleiner als 2n sind.

9. Schaltungsanordnung nach irgendeinem der Ansprüche 1 bis 8, bei der jede Veränderung von einer Ordnung in die nächste einen zugeordneten Segmentveränderungsparameter (SCP) hat, der berechnet wird, indem bei allen n Segmenten die jeweiligen Ordinalpositionsveränderungen, falls vorhanden, die durch die betreffende Ordnungsveränderung herbeigeführt werden, summiert werden, und ein Durchschnittswert des Segmentveränderungsparameters pro Zyklus kleiner als $n^2/64$ ist.

10. Schaltungsanordnung nach irgendeinem der Ansprüche 1 bis 8, bei der jede Veränderung von einer Ordnung in die nächste einen zugeordneten Segmentveränderungsparameter (SCP) hat, der berechnet wird, indem bei allen n Segmenten die jeweiligen Ordinalpositionsveränderungen, falls vorhanden, die durch die betreffende Ordnungsveränderung herbeigeführt werden, summiert werden, und ein Durchschnittswert des Segmentveränderungsparameters pro Zyklus kleiner als 16n ist.

11. Schaltungsanordnung nach irgendeinem der Ansprüche 1 bis 8, bei der jede Veränderung von einer Ordnung in die nächste einen zugeordneten Segmentveränderungsparameter (SCP) hat, der berechnet wird, indem bei allen n Segmenten die jeweiligen Ordinalpositionsveränderungen, falls vorhanden, die durch die betreffende Ordnungsveränderung herbeigeführt werden, summiert werden, und ein Durchschnittswert des Segmentveränderungsparameters pro Zyklus kleiner als 2n ist.

12. Schaltungsanordnung nach irgendeinem vorhergehenden Anspruch, bei der jede Veränderung von einer Ordnung in die nächste einen zugeordneten Segmentveränderungsparameter (SCP) hat, der berechnet wird, indem bei allen n Segmenten die jeweiligen Ordinalpositionsveränderungen, falls vorhanden, die durch die betreffende Ordnungsveränderung herbeigeführt werden, summiert werden, und eine Differenz zwischen jeweiligen minimalen und maximalen Werten des Segmentveränderungsparameters bezüglich der Anzahl n von Segmenten begrenzt ist.

13. Schaltungsanordnung nach irgendeinem vorhergehenden Anspruch, bei der das Morphing-Mittel betriebsfähig ist, um zu bewirken, daß die Anwendungsordnung der Segmentsteuersignale auf die Segmente in jeweils einem Zyklus aus einer Vielzahl von vorbestimmten verfügbaren Ordnungen selektiert wird.

14. Schaltungsanordnung nach Anspruch 13, bei der eine Gesamtanzahl der vorbestimmten verfügbaren Ordnungen größer als 4 ist.

15. Schaltungsanordnung nach Anspruch 13, bei der eine Gesamtanzahl der vorbestimmten verfügbaren Ordnungen größer gleich der Anzahl n von Segmenten ist.

16. Schaltungsanordnung nach Anspruch 13, 14 oder 15, bei der jede einzelne der vorbestimmten verfügbaren Ordnungen auf zufälliger oder pseudozufälliger Basis selektiert wird.

17. Schaltungsanordnung nach irgendeinem der Ansprüche 13 bis 15, bei der bewirkt wird, daß Ordnungsveränderungen, die insgesamt begrenztere Veränderungen der Ordinalposition einschließen, durchschnittlich häufiger auftreten als Ordnungsveränderungen, die insgesamt größere Veränderungen der Ordinalposition einschließen.

18. Schaltungsanordnung nach irgendeinem der Ansprüche 13 bis 16, bei der die vorbestimmten verfügbaren Ordnungen so sind, daß alle Ordnungsveränderungen ungefähr insgesamt dieselben Veränderungen der Ordinalposition einschließen, und bewirkt wird, daß alle Ordnungsveränderungen im Durchschnitt mit ungefähr derselben Häufigkeit stattfinden.

19. Schaltungsanordnung nach irgendeinem vorhergehenden Anspruch, bei der die Ordnungsveränderungen das Austauschen der jeweiligen Ordinalpositionen von Segmenten einschließen, die zu einem oder mehreren im voraus selektierten Paaren von Segmenten gehören.

20. Schaltungsanordnung nach irgendeinem vorhergehenden Anspruch, bei der ein durchschnittliches Zeitintervall zwischen Wiederholungen einer gegebenen Ordnungsveränderung wenigstens 0,1 $\mu$s beträgt.

21. Schaltungsanordnung nach irgendeinem vorhergehenden Anspruch, bei der das Morphing-Mittel betriebsfähig ist, um die n Segmente in m Gruppen von Segmenten zu unterteilen, wobei m≥2 ist, und betriebsfähig ist, um die Ordinalpositionen von Segmenten zu verändern, die zu derselben Gruppe gehören.

22. Schaltungsanordnung nach Anspruch 21, bei der Veränderungen der Ordinalposition durch das Morphing-Mittel in m-1 oder weniger von den m Gruppen zu jeweils einer Zeit zugelassen werden.

23. Schaltungsanordnung nach Anspruch 21, bei der Veränderungen der Ordinalposition durch das Morphing-Mittel nur in einer Gruppe zu jeweils einer Zeit zugelassen werden.

24. Schaltungsanordnung nach Anspruch 21, 22 oder 23, bei der n=128 und m=8 oder 16 ist.

25. Schaltungsanordnung nach irgendeinem der Ansprüche 21 bis 24, bei der die Ordinalpositionen von Segmenten, die zu derselben Gruppe gehören, über den Bereich von n möglichen Ordinalpositionen verbreitet sind.

26. Schaltungsanordnung nach irgendeinem vorhergehenden Anspruch, mit einer Decodiererschaltung (124), die jedem Segment entspricht und zum Empfangen des digitalen Eingangssignals und eines ID-Signals (M) verbunden ist und betriebsfähig ist, um einen logischen Zustand des Segmentsteuersignals, das auf ihr entsprechendes Segment angewendet wird, in Abhängigkeit von dem Resultat eines Vergleichs zwischen dem digitalen Eingangssignal und dem ID-Signal festzulegen;
wobei das Morphing-Mittel betriebsfähig ist, um zu bewirken, daß sich die jeweiligen ID-Signale, die durch die Decodiererschaltungen von verschiedenen Segmenten empfangen werden, verändern, um die Ordnungsveränderungen herbeizuführen.

27. Schaltungsanordnung nach Anspruch 26, in Verbindung mit irgendeinem der Ansprüche 21 bis 25, bei der Teile (32) der Decodiererschaltungen, die Segmenten entsprechen, die zu derselben Gruppe von Segmenten gehören, gemeinsam genutzt werden.

28. Schaltungsanordnung nach irgendeinem vorhergehenden Anspruch, ferner mit einem Segmentrotationsmittel, das in jedem genannten Zyklus betriebsfähig ist, um die Ordinalpositionen um r Segmente im Vergleich zu dem vorherigen Zyklus zu rotieren, wobei r ein Rotationsbetrag ist, der für den betreffenden Zyklus festgelegt wird.

29. Rauschformungsverfahren, zur Verwendung in einer Mischsignalschaltungsanordnung, die operativ ist, um eine Serie von Operationszyklen auszuführen, und n Schaltungsanordnungssegmente ($2_1$, $4_1$ bis $2_n$, $4_n$) umfaßt, die zusammen ein analoges Ausgangssignal ($I_A$-$I_B$) hervorbringen, welches Verfahren umfaßt:

Erzeugen, in jedem genannten Zyklus, in Abhängigkeit von einem digitalen Eingangssignal (D1-Dm), eines Satzes von n Segmentsteuersignalen (T1-Tn) zur Anwendung auf jeweilige der genannten Segmente, um das hervorgebrachte analoge Ausgangssignal zu beeinflussen;
**gekennzeichnet durch** Bewirken dessen, daß die n Segmentsteuersignale auf die n Segmente in wenigstens zwei verschiedenen Ordnungen zu jeweiligen verschiedenen Zeiten angewendet werden, wobei die Ordnungen so sind, daß sich wenigstens eine Ordnung von der nächsten Ordnung **durch** mehr als eine Startordinalposition unter den Segmenten unterscheidet und daß die Veränderungen der Ordinalposition der Segmente, die **durch** die Veränderungen der Anwendungsordnung der Segmentsteuersignale herbeigeführt werden, in der Zahl und/ oder der Größe bezüglich der Anzahl n von Segmenten begrenzt sind.

**Revendications**

1. Circuits de signaux mixtes agissant pour exécuter une série de cycles d'opérations comprenant :

n segments de circuits ($2_1$, $4_1$ à $2_n$, $4_n$) qui, ensemble, produisent un signal de sortie analogique ($I_A$ - $I_B$), et un moyen de génération de signal de commande (22) pouvant être mis en oeuvre dans chaque dit cycle pour générer, selon un signal d'entrée numérique (D1 à Dm) un ensemble de n signaux de commande de segment (T1 à Tn) pour une application aux segments respectifs parmi lesdits segments, pour influencer le signal de sortie analogique produit,

**caractérisés par** un moyen de transformation progressive (24) destiné à amener les n signaux de commande de segment à être appliqués aux n segments dans au moins deux ordres différents à des instants respectifs différents, lesdits ordres étant tels qu'au moins un ordre diffère de l'ordre suivant de plus d'une position d'ordre de début parmi les segments et que les changements de position d'ordre des segments provoqués par les changements de l'ordre d'application des signaux de commande de segment sont limités en nombre et/ou en amplitude par rapport audit nombre n de segments.

2. Circuits selon la revendication 1, dans lesquels, pour chaque changement d'ordre, il existe au moins un segment dont la position d'ordre n'est pas modifiée.

3. Circuits selon la revendication 1, dans lesquels, pour chaque changement d'ordre, au moins n/16 segments ne changent pas de position d'ordre.

4. Circuits selon la revendication 1, dans lesquels, pour chaque changement d'ordre, au plus n/2 segments subissent un changement de position d'ordre.

5. Circuits selon la revendication 1, dans lesquels, pour chaque changement d'ordre, au plus une paire de segments changent de position d'ordre.

6. Circuits selon l'une quelconque des revendications précédentes, dans lesquels chaque changement d'un ordre au suivant présente un paramètre de changement de segment associé, calculé en additionnant sur tous les n segments les changements de position d'ordre respectifs, s'il y en a, provoqués par les changements d'ordre concernés, et les paramètres de changement de segment respectifs associés aux changements d'ordre sont chacun inférieurs à $n^2/4$.

7. Circuits selon l'une quelconque des revendications 1 à 5, dans lesquels chaque changement d'un ordre au suivant présente un paramètre de changement de segment associé (SCP), calculé en additionnant sur tous les n segments, les changements de position d'ordre respectifs, s'il y en a, provoqués par le changement d'ordre concerné et les paramètres de changement de segment respectifs associés aux changements d'ordre sont chacun inférieurs ou égaux à 16n.

8. Circuits selon l'une quelconque des revendications 1 à 5, dans lesquels chaque changement d'un ordre au suivant, comporte un paramètre de changement de segment associé (SCP), calculé en additionnant sur tous les n segments, les changements de position d'ordre respectifs, s'il y en a, provoqués par un changement d'ordre concerné, et les paramètres de changement de segment respectifs associés aux changements d'ordres sont chacun inférieurs à 2n.

9. Circuits selon l'une quelconque des revendications 1 à 8, dans lesquels chaque changement d'un ordre au suivant comporte un paramètre de changement de segment associé (SCP), calculé en additionnant sur tous les n segments, les changements de position d'ordre respectifs, s'il y en a, provoqués par le changement d'ordre concerné, et une valeur moyenne dudit paramètre de changement de segment par cycle est inférieure à $n^2/64$.

10. Circuits selon l'une quelconque des revendications 1 à 8, dans lesquels chaque changement d'un ordre au suivant comporte un paramètre de changement de segment associé (SCP), calculé en additionnant sur tous les n segments, les changements de position d'ordre respectifs, s'il y en a, provoqués par le changement d'ordre concerné, et une valeur moyenne dudit paramètre de changement de segment par cycle est inférieure à 16n.

11. Circuits selon l'une quelconque des revendications 1 à 8, dans lesquels chaque changement d'un ordre au suivant présente un paramètre de changement de segment associé (SCP), calculé en additionnant sur tous les n segments les changements de position d'ordre respectifs, s'il y en a, provoqués par le changement d'ordre concerné, et une valeur moyenne dudit paramètre de changement de segment par cycle est inférieure à 2n.

12. Circuits selon l'une quelconque des revendications précédentes, dans lesquels chaque changement d'un ordre suivant présente un paramètre de changement de segment associé (SCP), calculé en additionnant sur tous les n segments les changements de position d'ordre respectifs, s'il y en a, provoqués par le changement d'ordre concerné et une différence entre des valeurs minimum et maximum respectives du paramètre de changement de segment est limitée par rapport audit nombre n de segments.

13. Circuits selon l'une quelconque des revendications précédentes, dans lesquels ledit moyen de transformation progressive peut être mis en oeuvre pour amener l'ordre d'application desdits signaux de commande de segment auxdits segments dans un cycle quelconque à être sélectionné à partir d'une pluralité d'ordres disponibles prédéterminés.

14. Circuits selon la revendication 13, dans lesquels un nombre total desdits ordres disponibles prédéterminés est supérieur à 4.

15. Circuits selon la revendication 13, dans lesquels un nombre total desdits ordres disponibles prédéterminés est supérieur ou égal audit nombre n de segments.

16. Circuits selon la revendication 13,14 ou 15, dans lesquels chacun desdits ordres disponibles prédéterminés est sélectionné sur une base aléatoire ou pseudoaléatoire.

17. Circuits selon l'une quelconque des revendications 13 à 15, dans lesquels des changements d'ordre qui impliquent plus de changements globaux limités de position d'ordre sont amenés à se produire en moyenne plus souvent que les changements d'ordre qui impliquent des changements globaux plus grands de position d'ordre.

18. Circuits selon l'une quelconque des revendications 13 à 16, dans lesquels lesdits ordres disponibles prédéterminés sont tels que tous les changements d'ordre impliquent appmacimativement les mêmes changements globaux de position d'ordre, et tous les changements d'ordre sont amenés à avoir lieu en moyenne approximativement avec les mêmes fréquences.

19. Circuits selon l'une quelconque des revendications précédentes, dans lesquels lesdits changements d'ordre impliquent la permutation des positions d'ordre respectives de segments appartenant à une ou plusieurs paires présélectionnées de segments.

20. Circuits selon l'une quelconque des revendications précédentes, dans lesquels un intervalle de temps moyen entre des répétitions d'un changement d'ordre donné est d'au moins 0,1 $\mu$s.

21. Circuits selon l'une quelconque des revendications précédentes, dans lesquels le moyen de transformation progressive peut être mis en oeuvre pour sous-diviser les n segments en m groupes de segments, où $m \geq 2$, et peut être mis en oeuvre pour modifier les positions d'ordre de segments appartenant au même groupe.

22. Circuits selon la revendication 21, dans lesquels des changements de position d'ordre sont permis par ledit moyen de transformation progressive en m -1, ou moins, desdits m groupes à un instant quelconque.

23. Circuits selon la revendication 21, dans lesquels les changements de position d'ordre sont permis par ledit moyen de transformation progressive dans un seul groupe à un instant quelconque.

24. Circuits selon la revendication 21, 22 ou 23, dans lesquels n =128 et m = 8 ou 16.

25. Circuits selon l'une quelconque des revendications 21 à 24, dans lesquels les positions d'ordre de segment appartenant au même groupe sont étalées sur la plage de n positions d'ordre possibles.

26. Circuits selon l'une quelconque des revendications précédentes, comportant un circuit de décodeur (124) correspondant à chaque segment et connecté pour recevoir ledit signal d'entrée numérique et un signal ID (M), et pouvant être mis en oeuvre pour établir un état logique du signal de commande de segment appliqué à son segment correspondant selon le résultat d'une comparaison entre ledit signal d'entrée numérique et ledit signal ID, ledit moyen de transformation progressive pouvant être mis en oeuvre pour amener les signaux ID respectifs reçus par les circuits de décodeurs de segments différents à changer pour provoquer lesdits changements de l'ordre.

27. Circuits selon la revendication 26, lorsqu'elle est comprise comme étant annexée à l'une quelconque des revendications 21 à 25, dans lesquels des parties (32) des circuits de décodeur correspondant aux segments appartenant au même groupe de segments sont partagées.

28. Circuits selon l'une quelconque des revendications précédentes, comprenant en outre un moyen de permutation circulaire de segment pouvant être mis en oeuvre dans chaque dit cycle pour faire effectuer une permutation circulaire auxdites positions d'ordre de r segments par comparaison au cycle précédent, où r est une valeur de permutation établie pour le cycle concerné.

29. Procédé de mise en forme de bruit, destiné à être utilisé dans les circuits de signaux mixtes qui agissent pour exécuter une série de cycles d'opérations et comprennent n segments de circuit ($2_1$, $4_1$ à $2_n$, $4_n$) qui produisent ensemble un signal de sortie analogique ($I_A$ - $I_B$), ledit procédé comprenant :

dans chaque dit cycle, la génération, en fonction d'un signal d'entrée numérique (D1 à Dm), d'un ensemble de n signaux de commande de segment (T1 à Tn) en vue d'une application aux segments respectifs parmi lesdits segments afin d'influencer le signal de sortie analogique,

**caractérisé par** le fait d'amener les n signaux de commande de segment à être appliqués aux n segments dans au moins deux ordres différents à des instants respectifs différents, lesdits ordres étant tels qu'au moins un ordre diffère de l'ordre suivant de plus d'une position d'ordre de départ parmi les segments et en ce que les changements de position d'ordre provoqués par les changements d'ordre d'application des signaux de commande de segment sont limités en nombre et/ou en amplitude par rapport audit nombre n des segments.

**BINARY - THERMOMETER DECODER**

*D1-Dm*

*Fig.1*

| BINARY INPUT WORD | | | THERMOMETER-CODED SIGNALS | | | | | | |
|---|---|---|---|---|---|---|---|---|---|
| D3 | D2 | D1 | T7 | T6 | T5 | T4 | T3 | T2 | T1 |
| 0 | 0 | 0 | 0 | 0 | 0 | 0 | 0 | 0 | 0 |
| 0 | 0 | 1 | 0 | 0 | 0 | 0 | 0 | 0 | 1 |
| 0 | 1 | 0 | 0 | 0 | 0 | 0 | 0 | 1 | 1 |
| 0 | 1 | 1 | 0 | 0 | 0 | 0 | 1 | 1 | 1 |
| 1 | 0 | 0 | 0 | 0 | 0 | 1 | 1 | 1 | 1 |
| 1 | 0 | 1 | 0 | 0 | 1 | 1 | 1 | 1 | 1 |
| 1 | 1 | 0 | 0 | 1 | 1 | 1 | 1 | 1 | 1 |
| 1 | 1 | 1 | 1 | 1 | 1 | 1 | 1 | 1 | 1 |

*Fig.2*

EP 1 202 459 B1

Fig.3

Fig.4(A)

Fig.4(B)

Fig.5(A)

Fig.5(B)

Fig.6(A)

Fig.6(B)

*Fig.7(A)*

*Fig.7(B)*

D1-Dm

22

20

MORPHING
CONTROL
SECTION

TRANSFER FUNCTION
MORPHING SECTION

M

24

$Vdd$       $Vdd$       $Vdd$

$2_n$     $2_2$     $2_1$

$I$     $Tn$       $I$     $T2$       $I$     $T1$

$4_n$     $4_2$     $4_1$

$A$

$I_A$

$B$

$R$     $R$

$V_A$     $V_B$

*Fig.8*

Fig.9(A)

POSITION IN TRANSFER FUNCTION

Fig.9(B)

POSITION IN TRANSFER FUNCTION

Fig.9(C)

POSITION IN TRANSFER FUNCTION

Fig.10(A)

Fig.10(B)

Fig.10(C)

| Ordinal position | First conversion cycle | | Second conversion cycle | | Third conversion cycle | |
|---|---|---|---|---|---|---|
| | Segment in that Ordinal position | Random source error of that segment | Segment in that Ordinal position | Random source error of that segment | Segment in that Ordinal position | Random source error of that segment |
| 0 | 0 | $e_0$ $(\mu+1)$ | 0 | $e_0$ $(\mu+1)$ | 0 | $e_0$ $(\mu+1)$ |
| 1 | 1 | $e_1$ $(\mu+1.5)$ | 5 | $e_5$ $(\mu-3)$ | 5 | $e_5$ $(\mu-3)$ |
| 2 | 2 | $e_2$ $(\mu-1)$ | 2 | $e_2$ $(\mu-1)$ | 4 | $e_4$ $(\mu+1)$ |
| 3 | 3 | $e_3$ $(\mu-0.5)$ | 3 | $e_3$ $(\mu-0.5)$ | 3 | $e_3$ $(\mu-0.5)$ |
| 4 | 4 | $e_4$ $(\mu+1)$ | 4 | $e_4$ $(\mu+1)$ | 2 | $e_2$ $(\mu-1)$ |
| 5 | 5 | $e_5$ $(\mu-3)$ | 1 | $e_1$ $(\mu+1.5)$ | 1 | $e_1$ $(\mu+1.5)$ |
| 6 | 6 | $e_6$ $(\mu-0.5)$ | 6 | $e_6$ $(\mu-0.5)$ | 6 | $e_6$ $(\mu-0.5)$ |
| 7 | 7 | $e_7$ $(\mu+1.5)$ | 7 | $e_7$ $(\mu+1.5)$ | 7 | $e_7$ $(\mu+1.5)$ |

*Fig.11*

EP 1 202 459 B1

EP 1 202 459 B1

Fig.12

35

| ID | B2 | B1 | B0 |
|----|----|----|----|
| 0 | 0 | 0 | 0 |
| 1 | 0 | 0 | 1 |
| 2 | 0 | 1 | 0 |
| 3 | 0 | 1 | 1 |
| 4 | 1 | 0 | 0 |
| 5 | 1 | 0 | 1 |
| 6 | 1 | 1 | 0 |
| 7 | 1 | 1 | 1 |

## Fig.13

| Segment | Morph_id[2] | Morph_id[1] | Morph_id[0] |
|---------|-------------|-------------|-------------|
| 0 | $B2$ | $B1$ | $B0$ |
| 1 | $B2$ | $B1$ | $\overline{B0}$ |
| 2 | $B2$ | $\overline{B1}$ | $B0$ |
| 3 | $B2$ | $\overline{B1}$ | $\overline{B0}$ |
| 4 | $\overline{B2}$ | $B1$ | $B0$ |
| 5 | $\overline{B2}$ | $B1$ | $\overline{B0}$ |
| 6 | $\overline{B2}$ | $\overline{B1}$ | $B0$ |
| 7 | $\overline{B2}$ | $\overline{B1}$ | $\overline{B0}$ |

## Fig.14

| ID | B2d | B2c | B2b | B2a | B1b | B1a | B0 |
|----|-----|-----|-----|-----|-----|-----|-----|
| 0 | X | X | X | 0 | X | 0 | 0 |
| 1 | X | X | 0 | X | 0 | X | 1 |
| 2 | X | 0 | X | X | X | 1 | 0 |
| 3 | 0 | X | X | X | 1 | X | 1 |
| 4 | X | X | X | 1 | X | 0 | 0 |
| 5 | X | X | 1 | X | 0 | X | 1 |
| 6 | X | 1 | X | X | X | 1 | 0 |
| 7 | 1 | X | X | X | 1 | X | 1 |

# Fig.15

| Segment | Morph_id[2] | Morph_id[1] | Morph_id[0] |
|---------|-------------|-------------|-------------|
| 0 | B2a | B1a | B0 |
| 1 | B2b | B1b | $\overline{B0}$ |
| 2 | B2c | $\overline{B1a}$ | B0 |
| 3 | B2d | $\overline{B1b}$ | $\overline{B0}$ |
| 4 | $\overline{B2a}$ | B1a | B0 |
| 5 | $\overline{B2b}$ | B1b | $\overline{B0}$ |
| 6 | $\overline{B2c}$ | $\overline{B1a}$ | B0 |
| 7 | $\overline{B2d}$ | $\overline{B1b}$ | $\overline{B0}$ |

# Fig.16

EP 1 202 459 B1

*Fig.17*

Group 0

Group 1

| S0 | S1 | S2 | S3 | S4 | S5 | S6 | S7 | S8 | S9 | S10 | S11 | S12 | S13 | S14 | S15 |
|----|----|----|----|----|----|----|----|----|----|-----|-----|-----|-----|-----|-----|

Fig.18

39

EP 1 202 459 B1

D1-Dm

LOCAL_EN   GROUP_EN   GROUP_ID

4          1          3

30

7

3 LSBS → GROUP DECODER   32

COMP
MORPH_ID_BUS

30

4 MSBS → SEGMENT 0 DECODER   $34_0$

4 MSBS → SEGMENT 1 DECODER   $34_1$

4

1

4 MSBS → SEGMENT 2 DECODER   $34_2$

4

1

4

1

MORPH_ID

4 MSBS → SEGMENT 14 DECODER   $34_{14}$

4

1

4 MSBS → SEGMENT 15 DECODER   $34_{15}$

4

1

16

T

*Fig.19*

40

*321*  *32*

D1-Dm (LSBs) —/—3— | LSB DECODER | —/—1—→ COMP
GROUP_ID —/—3—

LOCAL_EN —/—4— | MORPHING SIGNAL DECODER | —/—30—→ MORPH_ID_BUS
GROUP_EN —/—1—

*325*

## Fig.20

*321*

*322*

D1-Dm (LSBs) —/—3—
GROUP_ID —/—3—

—/—1—→ COMP

*323*

## Fig.21(A)

*325*

LOCAL_EN —/—4— | SWAP SELECTOR | d  q —/—15—
GROUP_EN —/—1— | | en  q̄ —/—15— | —/—30—→ MORPH_ID_BUS

*326*  *327*

## Fig.21(B)

*34*

*342*

D1-Dm (MSBs) —⁄/ **4**

COMP —⁄/ **1**

MORPH_ID —⁄/ **4**

*344*

**1** —⁄/ → T

SEGMENT DECODER

*Fig.22*

| Segment decoder no. | morph_id[3] | morph_id[2] | morph_id[1] | morph_id[0] |
|---|---|---|---|---|
| 0 | $\overline{B3a}$ | $\overline{B2a}$ | $\overline{B1a}$ | $\overline{B0}$ |
| 1 | $\overline{B3b}$ | $\overline{B2b}$ | $\overline{B1b}$ | $B0$ |
| 2 | $\overline{B3c}$ | $\overline{B2c}$ | $B1a$ | $\overline{B0}$ |
| 3 | $\overline{B3d}$ | $\overline{B2d}$ | $B1b$ | $B0$ |
| 4 | $\overline{B3e}$ | $B2a$ | $\overline{B1a}$ | $\overline{B0}$ |
| 5 | $\overline{B3f}$ | $B2b$ | $\overline{B1b}$ | $B0$ |
| 6 | $\overline{B3g}$ | $B2c$ | $B1a$ | $\overline{B0}$ |
| 7 | $\overline{B3h}$ | $B2d$ | $B1b$ | $B0$ |
| 8 | $B3a$ | $\overline{B2a}$ | $\overline{B1a}$ | $\overline{B0}$ |
| 9 | $B3b$ | $\overline{B2b}$ | $\overline{B1b}$ | $B0$ |
| 10 | $B3c$ | $\overline{B2c}$ | $B1a$ | $\overline{B0}$ |
| 11 | $B3d$ | $\overline{B2d}$ | $B1b$ | $B0$ |
| 12 | $B3e$ | $B2a$ | $\overline{B1a}$ | $\overline{B0}$ |
| 13 | $B3f$ | $B2b$ | $\overline{B1b}$ | $B0$ |
| 14 | $B3g$ | $B2c$ | $B1a$ | $\overline{B0}$ |
| 15 | $B3h$ | $B2d$ | $B1b$ | $B0$ |

# Fig.23

| Input enables | | Intermediate decode (select bit to toggle) | | | | | | | | | | | | | | |
|---|---|---|---|---|---|---|---|---|---|---|---|---|---|---|---|---|
| group_en | local_en | B3h | B3g | B3f | B3e | B3d | B3c | B3b | B3a | B2d | B2c | B2b | B2a | B1b | B1a | B0 |
| 0 | xxxx | 0 | 0 | 0 | 0 | 0 | 0 | 0 | 0 | 0 | 0 | 0 | 0 | 0 | 0 | 0 |
| 1 | 0000 | 0 | 0 | 0 | 0 | 0 | 0 | 0 | 0 | 0 | 0 | 0 | 0 | 0 | 0 | 1 |
| 1 | 0001 | 0 | 0 | 0 | 0 | 0 | 0 | 0 | 0 | 0 | 0 | 0 | 0 | 0 | 0 | 1 |
| 1 | 0010 | 0 | 0 | 0 | 0 | 0 | 0 | 0 | 0 | 0 | 0 | 0 | 0 | 0 | 1 | 0 |
| 1 | 0011 | 0 | 0 | 0 | 0 | 0 | 0 | 0 | 0 | 0 | 0 | 0 | 0 | 1 | 0 | 0 |
| 1 | 0100 | 0 | 0 | 0 | 0 | 0 | 0 | 0 | 0 | 0 | 0 | 0 | 1 | 0 | 0 | 0 |
| 1 | 0101 | 0 | 0 | 0 | 0 | 0 | 0 | 0 | 0 | 0 | 0 | 1 | 0 | 0 | 0 | 0 |
| 1 | 0110 | 0 | 0 | 0 | 0 | 0 | 0 | 0 | 0 | 0 | 1 | 0 | 0 | 0 | 0 | 0 |
| 1 | 0111 | 0 | 0 | 0 | 0 | 0 | 0 | 0 | 0 | 1 | 0 | 0 | 0 | 0 | 0 | 0 |
| 1 | 1000 | 0 | 0 | 0 | 0 | 0 | 0 | 0 | 1 | 0 | 0 | 0 | 0 | 0 | 0 | 0 |
| 1 | 1001 | 0 | 0 | 0 | 0 | 0 | 0 | 1 | 0 | 0 | 0 | 0 | 0 | 0 | 0 | 0 |
| 1 | 1010 | 0 | 0 | 0 | 0 | 0 | 1 | 0 | 0 | 0 | 0 | 0 | 0 | 0 | 0 | 0 |
| 1 | 1011 | 0 | 0 | 0 | 0 | 1 | 0 | 0 | 0 | 0 | 0 | 0 | 0 | 0 | 0 | 0 |
| 1 | 1100 | 0 | 0 | 0 | 1 | 0 | 0 | 0 | 0 | 0 | 0 | 0 | 0 | 0 | 0 | 0 |
| 1 | 1101 | 0 | 0 | 1 | 0 | 0 | 0 | 0 | 0 | 0 | 0 | 0 | 0 | 0 | 0 | 0 |
| 1 | 1110 | 0 | 1 | 0 | 0 | 0 | 0 | 0 | 0 | 0 | 0 | 0 | 0 | 0 | 0 | 0 |
| 1 | 1111 | 1 | 0 | 0 | 0 | 0 | 0 | 0 | 0 | 0 | 0 | 0 | 0 | 0 | 0 | 0 |

*Fig.24*

EP 1 202 459 B1

Fig.25(A)

POSITION IN TRANSFER
FUNCTION

Fig.25(B)

POSITION IN TRANSFER
FUNCTION

Fig.25(C)

POSITION IN TRANSFER
FUNCTION